(19) Europäisches Patentamt
European Patent Office
Office européen des brevets

(11) **EP 3 591 868 B1**

(12) **EUROPEAN PATENT SPECIFICATION**

(45) Date of publication and mention
of the grant of the patent:
**04.05.2022 Bulletin 2022/18**

(21) Application number: **18771996.8**

(22) Date of filing: **01.03.2018**

(51) International Patent Classification (IPC):
**H04L 1/00** (2006.01)

(52) Cooperative Patent Classification (CPC):
**H04L 1/0057; H04L 1/0061**

(86) International application number:
**PCT/CN2018/077744**

(87) International publication number:
**WO 2018/171401 (27.09.2018 Gazette 2018/39)**

(54) **INFORMATION PROCESSING METHOD, APPARATUS AND DEVICE**

INFORMATIONSVERARBEITUNGSVERFAHREN, EINRICHTUNG UND VORRICHTUNG

PROCÉDÉ, APPAREIL, ET DISPOSITIF DE TRAITEMENT D'INFORMATIONS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.03.2017 CN 201710185972**

(43) Date of publication of application:
**08.01.2020 Bulletin 2020/02**

(73) Proprietor: **Huawei Technologies Co., Ltd.**
**Longgang District**
**Shenzhen, Guangdong 518129 (CN)**

(72) Inventors:
• **ZHENG, Chen**
**Shenzhen**
**Guangdong 518129 (CN)**
• **LIU, Xiaojian**
**Shenzhen**
**Guangdong 518129 (CN)**
• **WEI, Yuejun**
**Shenzhen**
**Guangdong 518129 (CN)**
• **ZENG, Xin**
**Shenzhen**
**Guangdong 518129 (CN)**

(74) Representative: **Gill Jennings & Every LLP**
**The Broadgate Tower**
**20 Primrose Street**
**London EC2A 2ES (GB)**

(56) References cited:
**CN-A- 101 621 829     CN-A- 101 667 884**
**CN-A- 102 315 911     US-A1- 2014 068 375**

• **ERICSSON: "Code Block Segmentation for LDPC Codes", 3GPP DRAFT; R1-1701629 CODE BLOCK SEGMENTATION FOR LDPC CODES, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG1, no. Athens, Greece; 20170213 - 20170217 7 February 2017 (2017-02-07), XP051220832, Retrieved from the Internet: URL:http://www.3gpp.org/ftp/tsg_ran/WG1_RL 1/TSGR1_88/Docs/ [retrieved on 2017-02-07]**

**Description**

**TECHNICAL FIELD**

The present invention relates to the field of communications technologies, and in particular, to an information processing method and apparatus, and a device.

**BACKGROUND**

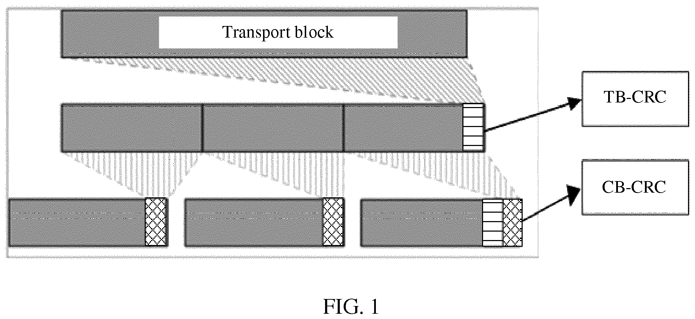

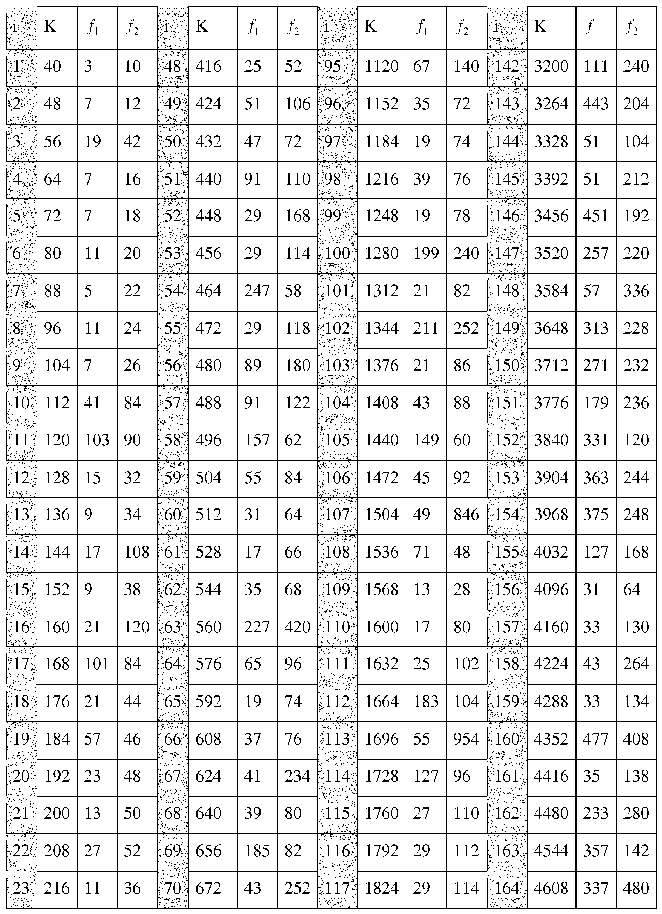

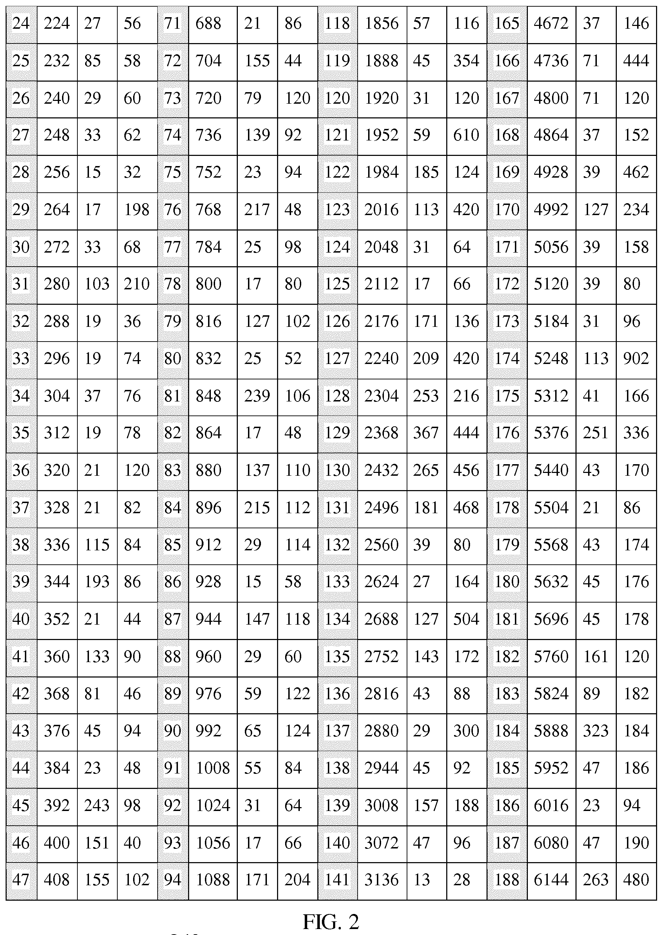

In an LTE protocol, a longest bit sequence supported by a turbo encoder during encoding is 6144 bits (bit). To support encoding of a longer bit sequence, a code block segmentation module is concatenated before the turbo encoder. The code block segmentation module is configured to segment a transport block (Transport Block, TB) larger than 6144 bits into a plurality of code blocks (Code Block, CB) for separate encoding. After turbo decoding, information data of different code blocks is concatenated to restore an original transport block (or referred to as "an information sequence"). FIG. 1 is a schematic diagram of a code block segmentation scenario. If a length B obtained after 24 TB-CRC bits are attached to the original transport block is greater than Z=6144 bits, block segmentation needs to be performed. After the block segmentation, CB-CRC bits of L=24 may be further added to each code block. Code block segmentation performed by using a turbo code is limited by a length of a quadratic polynomial permutation (Quadratic Polynomial Permutation, QPP) interleaver. A value of a length of each code block obtained after the segmentation needs to be equal to a value K in a turbo code interleaver parameter table shown in FIG. 2. The encoder may deduce, based on a determined value K, a quantity of code blocks into which the transport block is to be segmented.

A low-density parity-check code (Low Density Parity Check Code, LDPC) not only has good performance close to the Shannon (Shannon) limit, but also has relatively low decoding complexity and a flexible structure, and is a research hotspot in the field of channel encoding in recent years. A quasi-cyclic low-density parity-check code (Quasi-Cyclic Low Density Parity Check, QC-LDPC) is used as an example. An identity submatrix structure of this type of quasi-cyclic low-density parity-check code is very suitable for hardware implementing parallel operations, for example, a decoder with a high degree of parallelism and a high throughput rate. There is a parity-check matrix with a dual-diagonal structure or a raptor-like structure at a parity bit part, so encoding is very simple, and an incremental redundancy hybrid automatic repeat request technology can be supported. Currently, an LDPC code technology has been widely used in major communication standards. When the LDPC code technology is used, how to determine a quantity of code blocks into which a transport block is to be segmented is a problem that a person skilled in the art is studying.

3GPP TSG-RAN WG1 #88 teaches code block segmentation for LDPC codes. Specifically, the code block segmentation design takes into account both the maximum info block length $K_{max}$ and the maximum allowable codeword length $N_{max}$. The goal is that the LDPC decoder hardware is efficiently utilized for any combinations of information block length and code rate.

**SUMMARY**

To resolve a technical problem, embodiments of the present invention provide an information processing method and apparatus, and a device, so that a quantity of code blocks obtained through calculation can meet a channel encoding requirement.

According to a first aspect, an embodiment of the present invention provides an information processing method, and the method includes: obtaining a current modulation and coding scheme, MCS, based on a current channel status; determining, based on the obtained MCS, an encoding code rate of a transport block; and if a first code rate $R_{real}$ is greater than or equal to a second code rate $R_{min}$, determining, based on a maximum code block length $K_{max}$ of an LDPC, a quantity C of code blocks into which the transport block is to be segmented, where the first code rate $R_{real}$ is a largest one among the encoding code rate of the transport block, a code rate limit of the transport block, and a minimum code rate supported by the LDPC code, $R_{min,K}$, wherein the code rate limit of the transport block is $(TBS + L_{TB,CRC})/N_{IR}$, TBS is a length of the transport block, $L_{TB,CRC}$ is a length of cyclic redundancy check, CRC, bits of the transport block, and $N_{IR}$ is a size of a buffer used by the receive end to store soft information of the transport block, and the second code rate $R_{min}$ is a minimum code rate corresponding to the maximum code block length of the LDPC code, or a larger one between a minimum code rate corresponding to the maximum code block length of the LDPC code and a code rate limit of the maximum code block length of the LDPC code, wherein the code rate limit of the maximum code block length of the LDPC code is $K_{max}/N_{CB,limit}$, and $N_{CB,limit}$ is a size of a buffer used by a receive end to store soft information of the code block.

In the foregoing steps, it is determined, based on relative values of the first code rate and the second code rate, how to calculate the quantity of code blocks into which the transport block is to be segmented, instead of directly calculating, based on the maximum code block length of the LDPC code, the quantity of code blocks into which the transport block is to be segmented. In the calculation process, a size of a buffer used by a receive end to store soft information of a code block is used, so that the quantity of code blocks obtained through calculation is more appropriate.

With reference to the first aspect, in a first possible implementation of the first aspect, the method includes: if the first code rate $R_{real}$ is less than the second code rate $R_{min}$, determining, based on the first code rate $R_{real}$ and a maximum encoded length $N_{CB}$ of a code block, the quantity C of code blocks into which the transport block is to be segmented, where

if the second code rate $R_{min}$ is the minimum code rate corresponding to the maximum code block length of the LDPC code, $N_{CB}$ is a maximum encoded length $N_{max}$ of the LDPC code; or
if the second code rate $R_{min}$ is the larger one between the minimum code rate corresponding to the maximum code block length of the LDPC code and the code rate limit of the maximum code block length of the LDPC code, $N_{CB}$ is $N_{CB,limit}$, and $N_{CB,limit}$ is a size of a buffer used by a receive end to store soft information of the code block.

With reference to any one of the first aspect or the foregoing possible implementations of the first aspect, in a second possible implementation of the first aspect, the determining, based on a maximum code block length $K_{max}$ of an LDPC, a quantity of code blocks into which the transport block is to be segmented includes: determining, based on the maximum code block length $K_{max}$ of the LDPC, the quantity of code blocks into which the transport block is to be segmented, where a value of the quantity C of code blocks into which the transport block is to be segmented satisfies:

$$C = \left\lceil (TBS + L_{TB,CRC})/(K_{max} - L_{CB,CRC}) \right\rceil,$$

where

TBS is the length of the transport block, $L_{TB,CRC}$ is the length of the CRC bits of the transport block, and $L_{CB,CRC}$ is a length of CRC bits of the code block.

With reference to any one of the first aspect or the foregoing possible implementations of the first aspect, in a third possible implementation of the first aspect, the determining, based on the first code rate and a maximum encoded length $N_{CB}$ of a code block, the quantity of code blocks into which the transport block is to be segmented includes: determining, based on the first code rate and the maximum encoded length $N_{CB}$ of the code block, the quantity of code blocks into which the transport block is to be segmented, where a value of the quantity C of code blocks into which the transport block is to be segmented satisfies:

$$C = \left\lfloor (TBS + L_{TB,CRC})/(\lfloor R_{real} * N_{CB} \rfloor - L_{CB,CRC}) \right\rfloor,$$

or

$$C = \left\lceil (TBS + L_{TB,CRC})/(\lfloor R_{real} * N_{CB} \rfloor - L_{CB,CRC}) \right\rceil,$$

where

TBS is the length of the transport block, $L_{TB,CRC}$ is the length of the CRC bits of the transport block, and $L_{CB,CRC}$ is a length of CRC bits of the code block.

With reference to any one of the first aspect or the foregoing possible implementations of the first aspect, in a fourth possible implementation of the first aspect, if a sum of the length of the transport block and the length of the CRC bits of the transport block is greater than the maximum code block length of the LDPC, and the following condition ($TBS$ + $L_{TB,CRC}$)mod ($\lfloor R_{real} * N_{CB} \rfloor$ - $L_{CB,CRC}$) < $Th$ is satisfied, the value of C satisfies C = $\lfloor (TBS + L_{TB,CRC})/(\lfloor R_{real} * N_{CB} \rfloor - L_{CB,CRC}) \rfloor$, or

if a sum of the length of the transport block and the length of the CRC bits of the transport block is greater than the maximum code block length of the LDPC, and the following condition ($TBS$ + $L_{TB,CRC}$)mod ($\lfloor R_{real} * N_{CB} \rfloor$ - $L_{CB,CRC}$) $\geq Th$ is satisfied, the value of C satisfies C = $\lfloor (TBS + L_{TB,CRC})/(\lfloor R_{real} * N_{CB} \rfloor - L_{CB,CRC}) \rceil$, where Th is a preset threshold.

With reference to any one of the first aspect or the foregoing possible implementations of the first aspect, in a fifth possible implementation of the first aspect, the preset threshold Th is less than or equal to a difference between the maximum code block length of the LDPC and a length of $\lfloor R_{real} * N_{CB} \rfloor$ and is greater than 0.

According to a second aspect, an embodiment of the present invention provides an information processing apparatus, and the apparatus includes a processor and a memory. The memory is configured to store a transport block, and the processor is configured to perform the following operations: obtaining a current modulation and coding scheme, MCS, based on a current channel status; determining, based on the obtained MCS, an encoding code rate of the transport block; and if a first code rate $R_{real}$ is greater than or equal to a second code rate $R_{min}$, determining, based on a maximum code block length $K_{max}$ of an LDPC, a quantity C of code blocks into which the transport block is to be segmented, where the first code rate $R_{real}$ is a largest one among the encoding code rate of the transport block, a code rate limit of the transport block, and a minimum code rate supported by the LDPC code, $R_{min,K}$, wherein the code rate limit of the transport block is $(TBS + L_{TB,CRC})/N_{IR}$, TBS is a length of the transport block, $L_{TB,CRC}$ is a length of cyclic redundancy check, CRC, bits of the transport block, and $N_{IR}$ is a size of a buffer used by the receive end to store soft information of the transport block, and the second code rate $R_{min}$ is a minimum code rate corresponding to the maximum code block length of the LDPC code, or a larger one between a minimum code rate corresponding to the maximum code block length of the LDPC code and a code rate limit of the maximum code block length of the LDPC code, wherein the code rate limit of the maximum code block length of the LDPC code is $K_{MAX}/N_{CB,limit}$, and $N_{CB,limit}$ is a size of a buffer used by a receive end to store soft information of the code block.

In the foregoing operations, it is determined, based on relative values of the first code rate and the second code rate, how to calculate the quantity of code blocks into which the transport block is to be segmented, instead of directly calculating, based on the maximum code block length of the LDPC code, the quantity of code blocks into which the transport block is to be segmented. In the calculation process, a size of a buffer used by a receive end to store soft information of a code block is used, so that the quantity of code blocks obtained through calculation is more appropriate.

With reference to the second aspect, in a first possible implementation of the third aspect, if the first code rate $R_{real}$ is less than the second code rate $R_{min}$, the processor is configured to determine, based on the first code rate $R_{real}$ and a maximum encoded length $N_{CB}$ of a code block, the quantity C of code blocks into which the transport block is to be segmented, where

if the second code rate $R_{min}$ is the minimum code rate corresponding to the maximum code block length of the LDPC code, $N_{CB}$ is a maximum encoded length $N_{max}$ of the LDPC code; or
if the second code rate $R_{min}$ is the larger one between the minimum code rate corresponding to the maximum code block length of the LDPC code and the code rate limit of the maximum code block length of the LDPC code, $N_{CB}$ is $N_{CB,limit}$, and $N_{CB,limit}$ is a size of a buffer used by a receive end to store soft information of the code block.

With reference to any one of the second aspect or the foregoing possible implementations of the second aspect, in a second possible implementation of the second aspect, the processor is configured to determine, based on the maximum code block length $K_{max}$ of the LDPC, the quantity of code blocks into which the transport block is to be segmented, where a value of the quantity C of code blocks into which the transport block is to be segmented satisfies:

$$C = \left\lceil (TBS + L_{TB,CRC})/\left(K_{max} - L_{CB,CRC}\right)\right\rceil,$$

where
TBS is the length of the transport block, $L_{TB,CRC}$ is the length of the CRC bits of the transport block, and $L_{CB,CRC}$ is a length of CRC bits of the code block.
With reference to any one of the second aspect or the foregoing possible implementations of the second aspect, in a third possible implementation of the second aspect, the processor is configured to determine, based on the first code rate and the maximum encoded length $N_{CB}$ of the code block, the quantity of code blocks into which the transport block is to be segmented, where a value of the quantity C of code blocks into which the transport block is to be segmented satisfies:

$$C = \left\lceil (TBS + L_{TB,CRC})/\left(\lfloor R_{real} * N_{CB}\rfloor - L_{CB,CRC}\right)\right\rceil,$$

or

$$C = \left\lceil (TBS + L_{TB,CRC})/\left(\lfloor R_{real} * N_{CB}\rfloor - L_{CB,CRC}\right)\right\rceil,$$

where
TBS is the length of the transport block, $L_{TB,CRC}$ is the length of the CRC bits of the transport block, and $L_{CB,CRC}$ is a length of CRC bits of the code block.

With reference to any one of the second aspect or the foregoing possible implementations of the second aspect, in a fourth possible implementation of the second aspect, if a sum of the length of the transport block and the length of the CRC bits of the transport block is greater than the maximum code block length of the LDPC, and the following condition $(TBS + L_{TB,CRC})\mod(\lfloor R_{real} * N_{CB}\rfloor - L_{CB,CRC}) < Th$ is satisfied, the value of C satisfies $C = \lfloor (TBS + L_{TB,CRC})/(\lfloor R_{real} * N_{CB}\rfloor - L_{CB,CRC})\rfloor$, or

if a sum of the length of the transport block and the length of the CRC bits of the transport block is greater than the maximum code block length of the LDPC, and the following condition $(TBS + L_{TB,CRC})\mod(\lfloor R_{real} * N_{CB}\rfloor - L_{CB,CRC}) \geq Th$ is satisfied, the value of C satisfies $C = \lfloor (TBS + L_{TB,CRC})/(\lfloor R_{real} * N_{CB}\rfloor - L_{CB,CRC})\rceil$, where
Th is a preset threshold.

With reference to any one of the second aspect or the foregoing possible implementations of the second aspect, in a fifth possible implementation of the second aspect, the preset threshold Th is less than or equal to a difference between the maximum code block length of the LDPC and a length of $\lfloor R_{real} * N_{CB}\rfloor$ and is greater than 0.

According to a third aspect, an embodiment of the present invention provides a communications device, and the communications device includes the apparatus in the second aspect.

In the embodiments of the present invention, it is determined, based on the relative values of the first code rate and the second code rate, how to calculate the quantity of code blocks into which the transport block is to be segmented, instead of directly calculating, based on the maximum code block length of the LDPC code, the quantity of code blocks into which the transport block is to be segmented. In the calculation process, the size of the buffer used by the receive end to store the soft information of the code block is used, so that the quantity of code blocks obtained through calculation is more appropriate.

## BRIEF DESCRIPTION OF DRAWINGS

To describe the technical solutions in the embodiments of the present invention or in the background more clearly, the following briefly describes the accompanying drawings required for describing the embodiments of the present invention or the background.

FIG. 1 is a schematic diagram of a segmentation scenario of a transport block and a code block in the prior art;
FIG. 2 is a schematic diagram of a turbo code interleaver parameter table in the prior art;
FIG. 3 is a schematic structural diagram of a communications system according to an embodiment of the present invention;
FIG. 4 is a schematic flowchart of an information processing method according to an embodiment of the present invention;
FIG. 5 is a schematic diagram of a rate matching scenario according to an embodiment of the present invention;
FIG. 6 is a schematic diagram of comparison between information processing effects according to an embodiment of the present invention;
FIG. 7 is a schematic flowchart of another information processing method according to an embodiment of the present invention;
FIG. 8 is a schematic structural diagram of an apparatus according to an embodiment of the present invention;
FIG. 9 is a schematic structural diagram of another apparatus according to an embodiment of the present invention;
FIG. 10 is a schematic structural diagram of another apparatus according to an embodiment of the present invention; and
FIG. 11 is a schematic structural diagram of another apparatus according to an embodiment of the present invention.

## DESCRIPTION OF EMBODIMENTS

The following describes the embodiments of the present invention with reference to the accompanying drawings in the embodiments of the present invention.

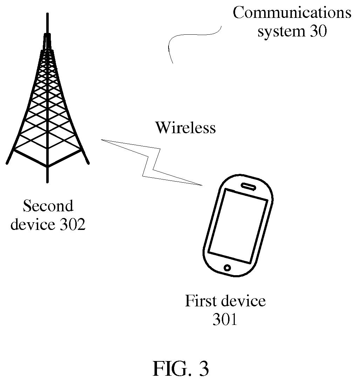

FIG. 3 is a schematic structural diagram of a communications system 30 according to an embodiment of the present invention. The system 30 includes a first device 301 and a second device 302. The first device 301 may communicate with the second device 302, and data sent in the communication process needs to be encoded. Information received by a receive end needs to be decoded to restore information before encoding by a transmit end. When the first device 301 functions as the transmit end, the second device 302 may function as the receive end. When the first device 301 functions as the receive end, the second device 302 may function as the transmit end. Both the first device 301 and the second device 302 may play different roles at different moments, for example, the first device 301 and the second device 302 each function as the receive end at a moment, and function as the transmit end at another moment. Optionally, the first device 301 may be user equipment in a cellular network. The user equipment may be a mobile phone, a tablet computer, a notebook computer, a palmtop computer, a mobile internet device (English: mobile internet device, MID for short), a wearable device (for example, a smartwatch (such as an iWatch), a smart band, or a pedometer), or the like. The second device 302 may be a network side device in the cellular network, for example, may be an eNodeB (eNodeB, eNB). When the communications system is a communications system based on a fifth-generation mobile communications technology (5th-Generation, 5G), the second device 302 may be a gNB (gNB) applicable to new radio (New Radio, NR). In a communications system based on another technology, the network device 301 may have another name. Examples are not enumerated herein.

The first device needs to calculate, based on a size TBS of a to-be-sent transport block and other related information, a quantity of code blocks into which the transport block needs to be segmented and a size (or referred to as a "length") of each code block. After obtaining the quantity of code blocks and the length of each code block through calculation, the first device segments the transport block based on the quantity and the length. After completing the segmentation, the first device independently encodes each code block and performs rate matching on each code block, and then performs a code block concatenation operation on the code blocks to combine the code blocks into one piece of information. This piece of information obtained through combination may be referred to as target information. The first device sends the target information to the second device.

The second device receives the target information. The second device also needs to calculate, based on the size TBS of the transport block and other related information, the quantity of code blocks into which the transport block needs to be segmented, the size (or referred to as the "length") of each code block, and a length obtained after rate matching of the transport block (which is the same as that performed by a rate matching module at the transmit end). Then the second device segments the target information based on the quantity of code blocks and the length of each code block that are obtained through calculation, and separately performs rate dematching, decoding, and a code block concatenation operation on code blocks obtained through segmentation, to restore data of the TBS.

It can be learned from the foregoing description that, both the first device and the second device need to calculate the quantity of code blocks into which the transport block is to be segmented, and a calculation rule may be agreed upon in advance according to a same protocol, so that the first device and the second device obtain a same result. In addition, the information used in the calculation process may be partially predefined in the protocol, or may be partially notified between the first device and the second device through communication. For example, the first device may send length information of the transport block to the second device, for use by the second device during subsequent calculation. In the following embodiments of the present invention, the first device is mainly used as an example to describe, by using the following several possible method procedures, how to calculate the quantity of code blocks into which the transport block is to be segmented. A calculation manner used by the second device to calculate the quantity of code blocks into which the transport block is to be segmented is the same as that used by the first device. Therefore, no additional description is provided in the embodiments of the present invention.

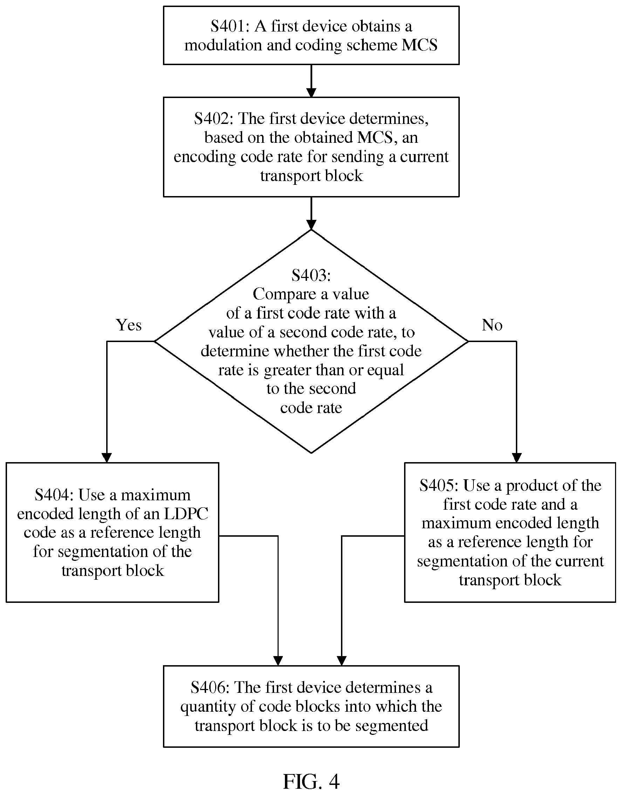

FIG. 4 is a schematic flowchart of an information processing method according to an embodiment of the present invention. The method includes but is not limited to the following steps.

Step S401: A first device obtains a current modulation and coding scheme (Modulation and Coding Scheme, MCS).

Specifically, the first device may determine the current modulation and coding scheme MCS based on a current channel status. Usually, if the channel status is good, the first device may select a high code rate and higher-order modulation, and if the channel status is not good, the first device may select a low code rate and lower-order modulation.

Step S402: The first device determines, based on the obtained MCS, an encoding code rate for sending a transport block.

Specifically, the first device prestores correspondences between a plurality of MCSs and a plurality of code rates. After determining a modulation and coding scheme, the first device may determine a code rate corresponding to the modulation and coding scheme based on the correspondence. In other words, the first device may obtain the encoding code rate R of the transport block based on the MCS.

Step S403: The first device compares a value of a first code rate with a value of a second code rate.

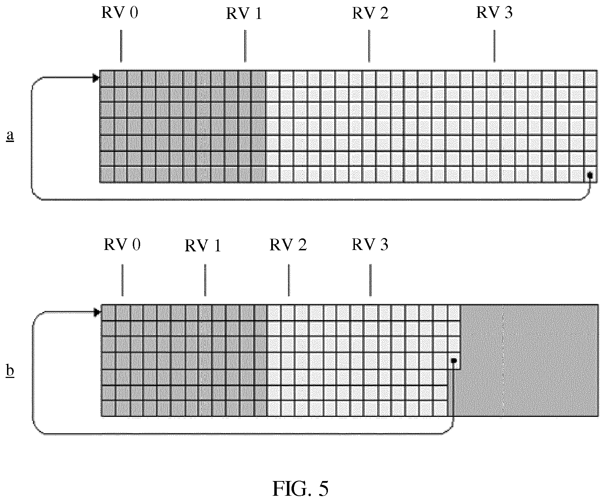

Specifically, bit information obtained after the transport block TB is segmented and encoded is transmitted to a receive end, and the receive end may input the information into a register. Limited buffer cases may exist in the register, for example, a transport block TB limited buffer case and a code block CB limited buffer case. The transport block TB limited buffer specifically means that there is an upper limit value for memory resources occupied in the register by bits information obtained by encoding the entire transport block. In other words, a size of a buffer used by the receive end to store soft information of the transport block may also be referred to as a transport block buffer upper limit $N_{IR}$. The code block CB limited buffer specifically means that there is an upper limit value for memory resources occupied in the register by bits information obtained by encoding a code block. In other words, a size of a buffer used by the receive end to store soft information of the code block may also be referred to as a code block buffer upper limit $N_{CB, limit}$. As shown in FIG. 5 (which is merely an example), a part a in FIG. 5 shows rate matching of a code block in a case of an unlimited buffer, and a part b in FIG. 5 shows rate matching of a code block in a case of a limited buffer. The limited buffer is mainly reflected by limited buffer resources. Available buffer resources of the limited buffer are usually fewer than available buffer resources of the unlimited buffer.

In different cases, the first code rate and the second code rate may be calculated in different manners. Examples are shown as follows:

When a transport block TB buffer is limited, the first device may calculate the first code rate based on a length of the transport block and the transport block buffer upper limit $N_{IR}$. For example, a calculation formula may be $R_{real} = max\{R, (TBS + L_{TB,CRC})/N_{IR}, R_{min,K}\}$, where $R_{real}$ is the first code rate, TBS is the length of the transport block, $L_{TB,CRC}$ is a length of cyclic redundancy check CRC bits of the transport block, $N_{IR}$ is the transport block buffer upper limit, $(TBS + L_{TB,CRC})/N_{IR}$ is a code rate obtained through calculation based on the transport block buffer upper limit $N_{IR}$, and may be referred to as a code rate limit, and $R_{min,K}$ is a minimum code rate of an LDPC code. The transport block buffer upper limit may be sent by the first device to a second device, or may be predefined in a communication protocol of the first device and a second device, or may be learned of by the first device in another manner.

When a code block CB buffer is limited, the first device may calculate the second code rate based on a maximum code block length of the LDPC and the code block buffer upper limit $N_{CB,limit}$. For example, a calculation formula may be $R_{min} = max(R_{min,K_{max}}, K_{max}/N_{CB,limit})$, where $R_{min}$ is the second code rate, $K_{max}$ is the maximum code block length of the LDPC, and $N_{CB,limit}$ is the code block buffer upper limit. The code block buffer upper limit $N_{CB,limit}$ may be sent by the first device to the second device, or may be predefined in the communication protocol of the first device and the second device, or may be learned of by the first device in another manner. In addition, this embodiment of the present invention further relates to a maximum encoded length $N_{max}$ (the maximum number of variable nodes (after lifting) of any parity check matrix, $N_{max}$) of the LDPC code. Usually, a system authorizes the maximum encoded length $N_{max}$ to indicate that the soft information of the code block cannot exceed the maximum encoded length $N_{max}$. When the code block buffer upper limit $N_{CB,limit}$ exists, a length obtained by encoding the code block actually cannot exceed $N_{CB,limit}$ or $N_{max}$. Therefore, $N_{CB} = min\{N_{max}, N_{CB,limit}\}$, to be specific, an actual maximum encoded length $N_{CB}$ is a smaller value in $N_{max}$ authorized by the system and $N_{CB,limit}$.

In an optional solution, the first code rate satisfies the following condition $R_{real} = max\{R, (TBS + L_{TB,CRC})/N_{IR}, R_{min,K}\}$, where $(TBS + L_{TB,CRC})/N_{IR}$ may be referred to as a code rate limit of the transport block, $R_{min,K}$ is a minimum code rate of an LDPC code (a minimum code rate supported by the LDPC code), TBS is a length of the transport block, $L_{TB,CRC}$ is a length of cyclic redundancy check CRC bits of the transport block. Optionally, numerous values for measuring a code block length are predefined for the LDPC code, and each value for measuring a code block length corresponds to one code rate range. If a length of a code block is exactly equal to the value for measuring a code block length, the code block may be encoded based on a code rate in the code rate range corresponding to the value for measuring a code block length. It may be understood that, there is a largest value in the numerous values for measuring a code block length that are predefined in the LDPC code, and the largest value may be referred to as a maximum code block length of the LDPC. There is a minimum code rate in a code rate range corresponding to the maximum code block length of the LDPC.

In an optional solution, the second code rate is a minimum code rate corresponding to the maximum code block length of the LDPC code, or a larger one between a minimum code rate corresponding to the maximum code block length of the LDPC code and a code rate limit of the maximum code block length of the LDPC code. When the second code rate is the larger one between the minimum code rate corresponding to the maximum code block length of the LDPC code and the code rate limit of the maximum code block length of the LDPC code, the second code rate satisfies the following condition $R_{min} = max(R_{min,K_{max}}, K_{max}/N_{CB,limit})$, and $K_{max}/N_{CB,limit}$ may be referred to as the code rate limit of the maximum code block length of the LDPC code.

Step S404: If the first code rate is greater than or equal to the second code rate, the first device uses a maximum code block length of the LDPC code as a reference length for segmentation of the transport block.

In other words, if $R_{real} \geq R_{min}$, it is determined that the reference length for segmentation of the transport block is $K_{CB,max} = K_{max}$.

Step S405: If the first code rate is less than the second code rate, the first device uses a product of the first code rate and a maximum encoded length $N_{CB}$ of a code block as a reference length for segmentation of the transport block.

In other words, if $R_{real} < R_{min}$, it is determined that the reference length for segmentation of the transport block is $K_{CB,max} = \lfloor N_{CB} * R_{real} \rfloor$.

Step S406: The first device determines a quantity of code blocks into which the transport block is to be segmented.

Specifically, the first device may perform step S406 after performing step S404 or step S405. The quantity of code blocks into which the transport block is to be segmented is determined before specific segmentation. In other words, after the quantity of code blocks into which the transport block is to be segmented is determined, the segmentation is performed based on information about the quantity. A determining manner may be as follows: Relative values of a sum $TBS + L_{TB,CRC}$ of the length TBS of the transport block and the length $L_{TB,CRC}$ of the cyclic redundancy check CRC bits of the transport block and the reference length $K_{CB,max}$ are compared. If $TBS + L_{TB,CRC} \leq K_{CB,max}$, the transport block does not need to be segmented, to be specific, the quantity C of code blocks CBs is C=1, and a length of the code block is $K = TBS + L_{TB,CRC}$. If $TBS + L_{TB,CRC} > K_{CB,max}$, further determining needs to be performed. A determining manner is as follows:

It is determined whether a remainder obtained by dividing a first parameter by a second parameter is less than a preset threshold Th. The first parameter is a parameter obtained through calculation based on the length (Transport Block Size, TBS) of the transport block. The second parameter is a parameter obtained through calculation based on the reference length $K_{CB,max}$. If the remainder is less than the preset threshold, the quantity of code blocks into which the transport block is to be segmented is equal to a rounded-down value obtained by dividing the first parameter by the second parameter. If the remainder is greater than the preset threshold, the quantity of code blocks into which the transport block is to be segmented is equal to a rounded-up value obtained by dividing the first parameter by the second parameter. In an optional solution, if the remainder obtained by dividing the first parameter by the second parameter is equal to the preset threshold Th, the quantity of code blocks into which the transport block is to be segmented is equal to a rounded-down value obtained by dividing the first parameter by the second parameter. In another optional solution, if the remainder obtained by dividing the first parameter by the second parameter is equal to the preset threshold Th, the quantity of code blocks into which the transport block is to be segmented is equal to a rounded-up value obtained by dividing the first parameter by the second parameter.

Optionally, the first parameter is equal to the sum $TBS + L_{TB,CRC}$ of the length TBS of the transport block and the length $L_{TB,CRC}$ of the cyclic redundancy check of the transport block, and the second parameter is equal to a difference $K_{CB,max} - L_{CB,CRC}$ between the reference length $K_{CB,max}$ and a length $L_{CB,CRC}$ of cyclic redundancy check CRC bits of the code block.

In other words, if $(TBS + L_{TB,CRC}) \bmod (K_{CB,max} - L_{CB,CRC}) < Th$, a value of C satisfies $C = \lfloor (TBS + L_{TB,CRC})/(K_{CB,max} - L_{CB,CRC}) \rfloor$. In this case, if the transport block is segmented in units of $K_{CB,max}$, a small part of bit information may remain. If one extra code block is obtained through segmentation due to this small part of extra information, a quantity of code blocks obtained through segmentation is consequently relatively large. In general, it is not worthwhile to obtain one extra block through segmentation due to this small part of extra bit information.

If $(TBS + L_{TB,CRC}) \bmod (K_{CB,max} - L_{CB,CRC}) \geq Th$, a value of C satisfies $C = \lceil (TBS + L_{TB,CRC})/(K_{CB,max} - L_{CB,CRC}) \rceil$. In this case, if the transport block is segmented in units of $K_{CB,max}$, a relatively large amount of bit information may remain. In this case, one extra code block may be obtained through segmentation by performing rounding up, so that the relatively large amount of bit information can be effectively transmitted.

It should be noted that, the preset threshold Th may be a parameter that is preconfigured based on an actual situation and that is used for comparison. Optionally, the preset threshold is less than or equal to a difference between the maximum code block length $K_{max}$ of the LDPC and the reference length $K_{CB,max}$ and is greater than 0. In other words, $0 < Th \leq K_{max} - K_{CB,max}$.

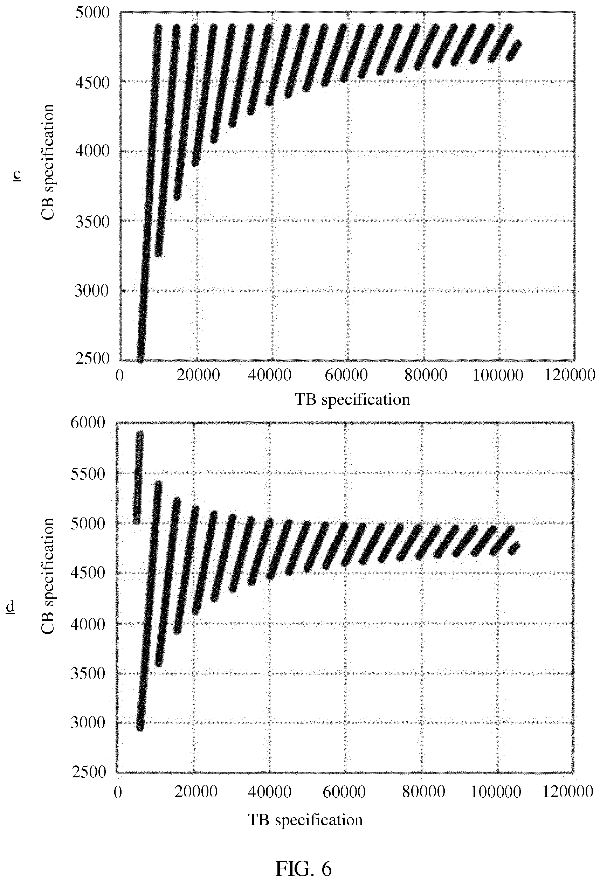

For ease of understanding, a specific example is used below for description. It is assumed that TBS = 19600, $L_{TB,CRC}$ = 24, $K_{CB,max}$ = 4915, $K_{max}$ = 6144, $L_{CB,CRC}$ = 24, and Th=100. When the defined maximum code block length of the LDPC code is $K_{CB,max}$ = 4915 bits, the corresponding minimum code rate is equal to 1/5. Based on these values, $TBS + L_{TB,CRC} > K_{CB,max}$ may be obtained. Therefore, it may be determined that the transport block is to be segmented into a plurality of code blocks. Based on these values, $(TBS + L_{TB,CRC}) \bmod (K_{CB,max} - L_{CB,CRC}) = 60$ may be further obtained. Because Th=100, $(TBS + L_{TB,CRC}) \bmod (K_{CB,max} - L_{CB,CRC}) < Th$ is satisfied. Therefore, $C = \lfloor (TBS + L_{TB,CRC})/(K_{CB,max} - L_{CB,CRC}) \rfloor = 4$. It may be understood that, if the transport block is to be segmented into four code blocks, a length of each code block is equal to (19600+24)/4=4906 bits, and after a CB CRC is added, a length of each code block is 4930 bits. The length of 4930 bits is slightly greater than $K_{CB,max}$. In addition, it may be learned through calculation that a code rate at which the code block having the length of 4930 bits is encoded is approximately equal to (4930)/(4915/(1/5))=0.2006, and this is very close to the code rate 1/5. Therefore, in terms of a code rate, there is no big difference in subsequent encoding, regardless of a 4915-bit code block or a 4930-bit code block obtained through segmentation. However, in terms of a quantity of code blocks obtained through segmentation, in this embodiment of the present invention, the quantity of code blocks obtained through segmentation is smaller, so that subsequent encoding performance can be improved. As shown in FIG. 6, a part c in FIG. 6 shows a relationship between a size TBSize of a transport block and a size CBSize of a code block obtained through segmentation in the prior art, and a part d in FIG. 6 shows a relationship between a size TBSize of a transport block and a size CBSize of a code block obtained through segmentation in this embodiment of the present invention. It can be learned that, in this embodiment of the present invention, a larger block length is used at a critical point, and the length of the code block obtained through segmentation is overall closer to the block length of 4915 bits corresponding to the code rate 1/5, thereby avoiding a performance loss caused by an excessively short code block length and an excessively large quantity of blocks obtained through segmentation.

In addition, during code block segmentation, there may be a code block group (CB Group) segmentation method, to be specific, several code blocks are used as a group and a CBG CRC is added to the group. In this case, a length $CG * L_{CBG,CRC}$ of cyclic redundancy check CRC bits of all code block groups further needs to be added to a length $(TBS + L_{TB,CRC})$ of the transport block before segmentation, where CG is a code block group quantity, and $L_{CBG,CRC}$ is a length of cyclic redundancy check CRC bits of a code block group. For example, during calculation of the code rate limit of the transport block, $(TBS + L_{TB,CRC} + CG * L_{CBG,CRC})/N_{IR}$ is used. For another example, $C = \llcorner(TBS + L_{TB,CRC} + CG * L_{CBG,CRC})/(K_{CB,max} - L_{CB,CRC})\lrcorner$.

In the method in FIG. 4, the first device determines, based on relative values of the first code rate and the second code rate, how to calculate the quantity of code blocks into which the transport block is to be segmented, instead of directly calculating, based on the maximum code block length of the LDPC code, the quantity of code blocks into which the transport block is to be segmented. In the calculation process, the size of the buffer used by the receive end to store the soft information of the code block is used, so that the quantity of code blocks obtained through calculation is more appropriate.

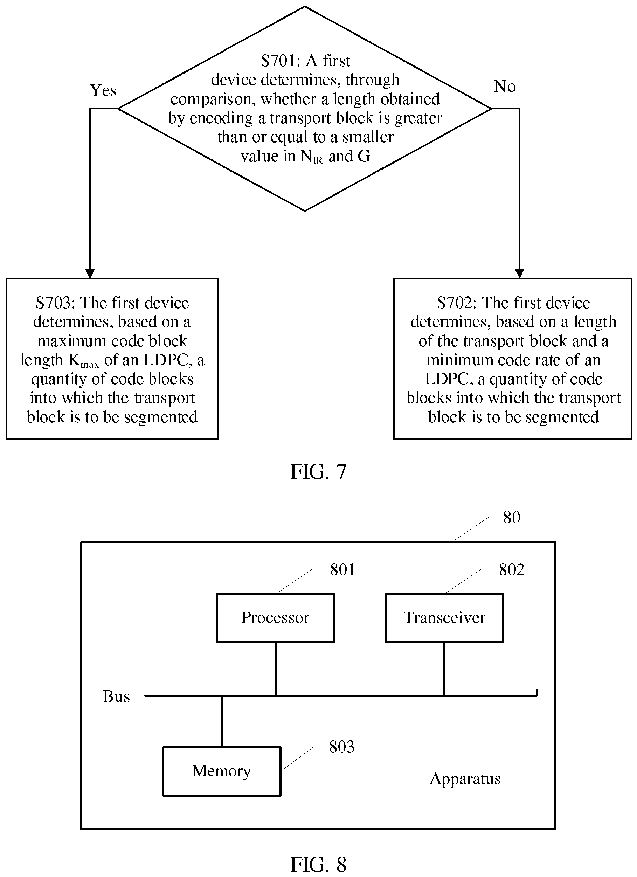

FIG. 7 is a schematic flowchart of another information processing method according to an embodiment of the present invention. The method includes but is not limited to the following steps.

Step S701: A first device compares a value of a length obtained by encoding a transport block based on $R_{min,K_{max}}$ with a smaller value in $N_{IR}$ and G.

Specifically, the length obtained by encoding the transport block based on $R_{min,K_{max}}$ may be calculated based on a third parameter and $R_{min,K_{max}}$. The third parameter is equal to a length TBS of the transport block or a value obtained through calculation based on a length TBS of the transport block. When the third parameter is the value obtained through calculation based on the length TBS of the transport block, optionally, the third parameter is equal to a sum of the length TBS of the transport block and a length $L_{TB,CRC}$ of cyclic redundancy check CRC bits of the transport block. This may be expressed in the following formula: the third parameter $X3 = TBS + L_{TB,CRC}$. A value obtained by dividing the third parameter X3 by $R_{min,K_{max}}$ is equal to the length obtained by encoding the transport block based on $R_{min,K_{max}}$.

It should be noted that, numerous values for measuring a code block length may be predefined in an LDPC code, and each value for measuring a code block length corresponds to one code rate range. If a length of a code block is exactly equal to the value for measuring a code block length, the code block may be encoded based on a code rate in the code rate range corresponding to the value for measuring a code block length. It may be understood that, there is a largest value in the numerous values for measuring a code block length that are predefined in the LDPC code, and the largest value may be referred to as a maximum code block length of the LDPC. There is a minimum code rate $R_{min,K_{max}}$ in a code rate range corresponding to the maximum code block length $K_{max}$ of the LDPC.

It should be noted that, $R_{min,K_{max}}$ is the minimum code rate corresponding to the maximum code block length of the LDPC, $N_{IR}$ is a size of a buffer used by a receive end to store soft information of the transport block, and G is a quantity of authorized bits used to transmit the transport block. $N_{IR}$ and G may be defined in a communication protocol of a transmit end and the receive end, so that both the transmit end and the receive end can learn of $N_{IR}$ and G. Alternatively, $N_{IR}$ and G may be configured at the receive end, so that if a transmit end needs to learn of $N_{IR}$ and G, the receive end may send $N_{IR}$ and G to the transmit end.

Step S702: If the length obtained by encoding the transport block based on $R_{min,K_{max}}$ is greater than or equal to the smaller value in $N_{IR}$ and G, the first device determines, based on a maximum code block length $K_{max}$ of an LDPC, a quantity of code blocks into which the transport block is to be segmented.

Specifically, a rounded-up value obtained by dividing the third parameter by a fourth parameter may be determined as the quantity of code blocks CBs into which the transport block is to be segmented. Optionally, the fourth parameter is equal to the maximum code block length of the LDPC code or a value obtained through calculation based on the maximum code block length of the LDPC. When the fourth parameter is equal to the value obtained through calculation based on the maximum code block length $K_{max}$ of the LDPC, optionally, the fourth parameter is equal to a sum of the maximum code block length $K_{max}$ of the LDPC and a length $L_{CB,CRC}$ of cyclic redundancy check CRC bits of the code block. This may be expressed in the following formula: the fourth parameter $X4 = K_{max} + L_{CB,CRC}$.

It may be understood that, when a size of the transport block is relatively large, the transport block needs to be segmented before transmission to obtain code blocks that have sizes smaller than that of the transport block. A quantity of code blocks into which the transport block is to be segmented needs to be determined before formal segmentation. It can be learned from the foregoing description that, in an optional solution, if $(TBS + L_{TB,CRC})/R_{min,K_{max}} \geq \min(G,N_{IR})$, the quantity of code blocks is $C = \lceil(TBS + L_{TB,CRC})/(K_{max} - L_{CB,CRC})\rceil$.

Step S703: If the length obtained by encoding the transport block based on $R_{min,K_{max}}$ is less than the smaller value in $N_{IR}$ and G, the first device determines, based on a length of the transport block and a minimum code rate of an LDPC, a quantity of code blocks into which the transport block is to be segmented.

Specifically, the first device calculates, based on a value obtained by dividing the third parameter by the minimum code rate of the LDPC, the quantity of code blocks into which the transport block is to be segmented.

Specifically, the minimum code rate of the LDPC is a minimum code rate supported by the LDPC code, and may be denoted by $R_{min,K}$. For ease of subsequent description, the value obtained by dividing the third parameter by the minimum code rate of the LDPC may be referred to as a fifth parameter. In other words, the fifth parameter X5 = $(TBS + L_{TB,CRC})/R_{min,K}$. The quantity of code blocks into which the transport block is to be segmented may be calculated based on the fifth parameter.

In an optional solution, a rounded-up value obtained by dividing a smallest value in the fifth parameter, $N_{IR}$, and G by a sixth parameter is determined as the quantity of code blocks into which the transport block is to be segmented. The sixth parameter $N_{CB}$ is equal to a smaller value in a size $N_{CB,limit}$ of a buffer used by the receive end to store soft information of the code block and a maximum encoded length $N_{max}$ of the LDPC code. $N_{CB,limit}$ and $N_{max}$ may be defined in the communication protocol of the transmit end and the receive end, so that both the transmit end and the receive end can learn of $N_{CB,limit}$ and $N_{max}$. Alternatively, $N_{CB,limit}$ and $N_{max}$ may be configured at the receive end, so that if the transmit end needs to learn of $N_{CB,limit}$ and $N_{max}$, the receive end may send $N_{CB,limit}$ and $N_{max}$ to the transmit end. It can be learned from the foregoing description that, if $(TBS + L_{TB,CRC})/R_{min,Kmax} < min(G, N_{IR})$, the quantity of code blocks is $\lceil min((TBS + L_{TB,CRC})/R_{min,K}, G, N_{IR})/N_{CB} \rceil$. In other words, the smallest value in G, $N_{IR}$, and the fifth parameter X5 is used, and a rounded-up value obtained by dividing the smallest value by the sixth parameter is used as the quantity of code blocks into which the transport block needs to be segmented.

In addition, during code block segmentation, there may be a code block group (CB Group) segmentation method, to be specific, several code blocks are used as a group and a CBG CRC is added to the group. In this case, a length CG * $L_{CBG,CRC}$ of cyclic redundancy check CRC bits of all code block groups further needs to be added to a length $(TBS + L_{TB,CRC})$ of the transport block before segmentation, where CG is a code block group quantity, and $L_{CBG,CRC}$ is a length of cyclic redundancy check CRC bits of a code block group. For example, the fifth parameter X5=(TBS + $L_{TB,CRC}$ + CG * $L_{CBG,CRC}$)/$R_{min,K}$ For another example, C = $\lceil min((TBS + L_{TB,CRC} + CG * L_{CBG,CRC})/R_{min,K}, G, N_{IR})/N_{CB} \rceil$.

In the method in FIG. 7, the first device compares an estimated length obtained by encoding the transport block with a smaller value in the size of the buffer used by the receive end to store the soft information of the code block and a quantity of bits that are authorized by a system and that are used to transmit the transport block. If the estimated length obtained by encoding the transport block is larger, the quantity of code blocks into which the transport block is to be segmented is determined based on the maximum code block length $K_{max}$ of the LDPC. If the estimated length obtained by encoding the transport block is smaller, the quantity of code blocks into which the transport block is to be segmented is determined based on the length of the transport block and the minimum code rate of the LDPC. In this process, the size of the buffer used by the receive end to store the soft information of the code block is considered, so that the quantity of code blocks obtained through calculation is more appropriate.

The method in the embodiments of the present invention is described in detail above. An apparatus in the embodiments of the present invention is provided below.

FIG. 8 shows an apparatus 80 according to an embodiment of the present invention. The apparatus 80 includes a processor 801, a memory 802, and a transceiver 803. The processor 801, the memory 802, and the transceiver 803 are interconnected through a bus.

The memory 802 includes but is not limited to a random access memory (English: Random Access Memory, RAM for short), a read-only memory (English: Read-Only Memory, ROM for short), an erasable programmable read only memory (English: Erasable Programmable Read Only Memory, EPROM for short), or a portable read-only memory (English: Compact Disc Read-Only Memory, CD-ROM for short). The memory 802 is configured to store a related instruction or data, for example, a transport block. The transceiver 803 is configured to receive and send data.

The processor 801 may be one or more central processing units (English: Central Processing Unit, CPU for short). When the processor 801 is one CPU, the CPU may be a single-core CPU, or may be a multi-core CPU.

The processor 801 in the apparatus 80 is configured to perform an information processing operation, or is configured to read program code stored in the memory 802, to perform an information processing operation. The information process operation specifically includes:

obtaining an encoding code rate of the transport block; and if a first code rate $R_{real}$ is greater than or equal to a second code rate $R_{min}$, determining, based on a maximum code block length $K_{max}$ of an LDPC, a quantity C of code blocks into which the transport block is to be segmented, where the first code rate $R_{real}$ is a largest one among the encoding code rate of the transport block, a code rate limit of the transport block, and a minimum code rate of the LDPC code, and the second code rate $R_{min}$ is a minimum code rate corresponding to the maximum code block length of the LDPC code, or a larger one between a minimum code rate corresponding to the maximum code block length of the LDPC code and a code rate limit of the maximum code block length of the LDPC code.

In the foregoing operations, it is determined, based on relative values of the first code rate and the second code rate, how to calculate the quantity of code blocks into which the transport block is to be segmented, instead of directly calculating, based on the maximum code block length of the LDPC code, the quantity of code blocks into which the transport block is to be segmented. In the calculation process, a size of a buffer used by a receive end to store soft information of a code block is used, so that the quantity of code blocks obtained through calculation is more appropriate.

In an optional solution, if the first code rate $R_{real}$ is less than the second code rate $R_{min}$, the processor is configured to determine, based on the first code rate $R_{real}$ and a maximum encoded length $N_{CB}$ of a code block, the quantity C of code blocks into which the transport block is to be segmented, where

if the second code rate $R_{min}$ is the minimum code rate corresponding to the maximum code block length of the LDPC code, $N_{CB}$ is a maximum encoded length $N_{max}$ of the LDPC code; or if the second code rate $R_{min}$ is the larger one between the minimum code rate corresponding to the maximum code block length of the LDPC code and the code rate limit of the maximum code block length of the LDPC code, $N_{CB}$ is $N_{CB,limit}$, and $N_{CB,limit}$ is a size of a buffer used by a receive end to store soft information of the code block.

In another optional solution, the code rate limit of the maximum code block length of the LDPC code is $K_{max}/N_{CB,limit}$, and $N_{CB,limit}$ is the size of the buffer used by the receive end to store the soft information of the code block.

In another optional solution, the code rate limit of the transport block is $(TBS + L_{TB,CRC})/N_{IR}$, TBS is a length of the transport block, $L_{TB,CRC}$ is a length of cyclic redundancy check CRC bits of the transport block, and $N_{IR}$ is a size of a buffer used by the receive end to store soft information of the transport block.

In another optional solution, the processor is configured to determine, based on the maximum code block length $K_{max}$ of the LDPC, the quantity of code blocks into which the transport block is to be segmented, where a value of the quantity C of code blocks into which the transport block is to be segmented satisfies:

$$C = \left\lceil (TBS + L_{TB,CRC})/(K_{max} - L_{CB,CRC}) \right\rceil,$$

where

TBS is the length of the transport block, $L_{TB,CRC}$ is the length of the CRC bits of the transport block, and $L_{CB,CRC}$ is a length of CRC bits of the code block.

In another optional solution, the processor is configured to determine, based on the first code rate and the maximum encoded length $N_{CB}$ of the code block, the quantity of code blocks into which the transport block is to be segmented, where a value of the quantity C of code blocks into which the transport block is to be segmented satisfies:

$$C = \left\lfloor (TBS + L_{TB,CRC})/(\lfloor R_{real} * N_{CB} \rfloor - L_{CB,CRC}) \right\rfloor,$$

or

$$C = \left\lceil (TBS + L_{TB,CRC})/(\lfloor R_{real} * N_{CB} \rfloor - L_{CB,CRC}) \right\rceil,$$

where

TBS is the length of the transport block, $L_{TB,CRC}$ is the length of the CRC bits of the transport block, and $L_{CB,CRC}$ is a length of CRC bits of the code block.

In another optional solution, if a sum of the length of the transport block and the length of the CRC bits of the transport block is greater than the maximum code block length of the LDPC, and the following condition $(TBS + L_{TB,CRC})\bmod (\lfloor R_{real} * N_{CB} \rfloor - L_{CB,CRC}) < Th$ is satisfied, the value of C satisfies $C = \lfloor (TBS + L_{TB,CRC})/(\lfloor R_{real} * N_{CB} \rfloor - L_{CB,CRC}) \rfloor$, or

if a sum of the length of the transport block and the length of the CRC bits of the transport block is greater than the maximum code block length of the LDPC, and the following condition $(TBS + L_{TB,CRC})\bmod (\lfloor R_{real} * N_{CB} \rfloor - L_{CB,CRC}) \geq Th$ is satisfied, the value of C satisfies $C = \lfloor (TBS + L_{TB,CRC})/(\lfloor R_{real} * N_{CB} \rfloor - L_{CB,CRC}) \rceil$, where Th is a preset threshold.

In another optional solution, the preset threshold Th is less than or equal to a difference between the maximum code block length of the LDPC and a length of $\lfloor R_{real} * N_{CB} \rfloor$ and is greater than 0.

It should be noted that, for implementations of the operations, refer to the corresponding descriptions of the method embodiment shown in FIG. 4.

In the apparatus 80 in FIG. 8, it is determined, based on the relative values of the first code rate and the second code rate, how to calculate the quantity of code blocks into which the transport block is to be segmented, instead of directly calculating, based on the maximum code block length of the LDPC code, the quantity of code blocks into which the transport block is to be segmented. In the calculation process, the size of the buffer used by the receive end to store the soft information of the code block is used, so that the quantity of code blocks obtained through calculation is more appropriate.

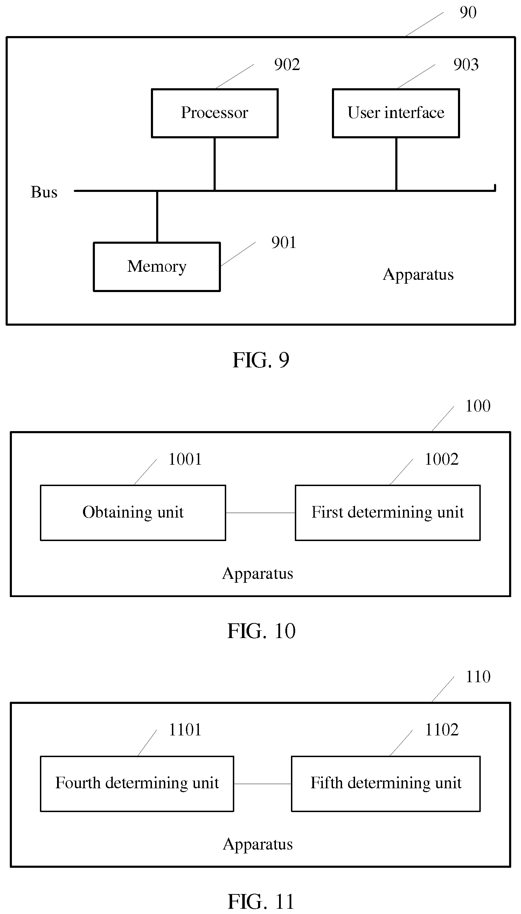

FIG. 9 shows an apparatus 90 according to an embodiment of the present invention. The apparatus 90 includes a processor 901, a memory 902, and a transceiver 903. The processor 901, the memory 902, and the transceiver 903 are interconnected through a bus.

The memory 902 includes but is not limited to a random access memory (English: Random Access Memory, RAM for short), a read-only memory (English: Read-Only Memory, ROM for short), an erasable programmable read only memory (English: Erasable Programmable Read Only Memory, EPROM for short), or a portable read-only memory (English: Compact Disc Read-Only Memory, CD-ROM for short). The memory 902 is configured to store a related instruction or data, for example, a transport block or program code. The transceiver 903 is configured to receive and send data.

The processor 901 may be one or more central processing units (English: Central Processing Unit, CPU for short). When the processor 901 is one CPU, the CPU may be a single-core CPU, or may be a multi-core CPU.

The processor 901 in the apparatus 90 is configured to perform an information processing operation, or is configured to read the program code stored in the memory 902, to perform an information processing operation. The information process operation specifically includes:

determining whether a length obtained by encoding the transport block based on $R_{min,K_{max}}$ is greater than or equal to a smaller value in $N_{IR}$ and G, where $R_{min,K_{max}}$ is a minimum code rate corresponding to a maximum code block length of an LDPC, $N_{IR}$ is a size of a buffer used by a receive end to store soft information of the transport block, and G is a quantity of authorized bits used to transmit the transport block; and if the length obtained by encoding the transport block based on $R_{min,K_{max}}$ is greater than or equal to the smaller value in $N_{IR}$ and G, determining, based on the maximum code block length $K_{max}$ of the LDPC, a quantity of code blocks into which the transport block is to be segmented.

In the foregoing operations, an estimated length obtained by encoding the transport block is compared with a smaller value in a size of a buffer used by the receive end to store soft information of a code block and a quantity of bits that are authorized by a system and that are used to transmit the transport block. If the estimated length obtained by encoding the transport block is larger, the quantity of code blocks into which the transport block is to be segmented is determined based on the maximum code block length $K_{max}$ of the LDPC. If the estimated length obtained by encoding the transport block is smaller, the quantity of code blocks into which the transport block is to be segmented is determined based on a length of the transport block and a minimum code rate of the LDPC. In this process, the size of the buffer used by the receive end to store the soft information of the code block is considered, so that the quantity of code blocks obtained through calculation is more appropriate.

In an optional solution, if the length obtained by encoding the transport block based on $R_{min,K_{max}}$ is less than the smaller value in $N_{IR}$ and G, the processor is configured to determine, based on a length of the transport block and a minimum code rate of the LDPC, the quantity of code blocks into which the transport block is to be segmented.

In another optional solution, the processor is configured to determine, based on the length of the transport block and the minimum code rate of the LDPC, the quantity of code blocks into which the transport block is to be segmented, where a value of the quantity C of code blocks into which the transport block is to be segmented satisfies:

$$C = \left\lceil \min\left((TBS + L_{TB,CRC})/R_{min,K}, G, N_{IR}\right)/N_{CB} \right\rceil,$$

or

$$C = \left\lfloor \min\left((TBS + L_{TB,CRC})/R_{min,K}, G, N_{IR}\right)/N_{CB} \right\rfloor,$$

where

TBS is the length of the transport block, $L_{TB,CRC}$ is a length of cyclic redundancy check CRC bits of the transport block, $R_{min,K}$ is the minimum code rate of the LDPC, and $N_{CB}$ is a smaller value in a maximum encoded length $N_{max}$ of the LDPC code and a size of a buffer used by the receive end to store soft information of the code block.

In another optional solution, the processor is configured to determine, based on the maximum code block length $K_{max}$ of the LDPC, the quantity of code blocks into which the transport block is to be segmented, where the value of the quantity C of code blocks into which the transport block is to be segmented satisfies:

$$C = \left\lceil (TBS + L_{TB,CRC})/\left(K_{max} - L_{CB,CRC}\right) \right\rceil,$$

where

TBS is the length of the transport block, $L_{TB,CRC}$ is the length of the cyclic redundancy check CRC bits of the transport block, and $L_{CB,CRC}$ is a length of CRC bits of the code block.

It should be noted that, for implementations of the operations, refer to the corresponding descriptions of the method embodiment shown in FIG. 7.

In the apparatus 90 in FIG. 9, the estimated length obtained by encoding the transport block is compared with the smaller value in the size of the buffer used by the receive end to store the soft information of the code block and the quantity of bits that are authorized by the system and that are used to transmit the transport block. If the estimated length obtained by encoding the transport block is larger, the quantity of code blocks into which the transport block is to be segmented is determined based on the maximum code block length $K_{max}$ of the LDPC. If the estimated length obtained by encoding the transport block is smaller, the quantity of code blocks into which the transport block is to be segmented is determined based on the length of the transport block and the minimum code rate of the LDPC. In this process, the size of the buffer used by the receive end to store the soft information of the code block is considered, so that the quantity of code blocks obtained through calculation is more appropriate.

FIG. 10 is a schematic structural diagram of an apparatus 100 according to an embodiment of the present invention. The apparatus 100 may include an obtaining unit 1001 and a first determining unit 1002. Detailed descriptions of the units are as follows:

The obtaining unit 1001 is configured to obtain an encoding code rate of a transport block. If a first code rate $R_{real}$ is greater than or equal to a second code rate $R_{min}$, the first determining unit 1002 is configured to determine, based on a maximum code block length $K_{max}$ of an LDPC, a quantity C of code blocks into which the transport block is to be segmented. The first code rate $R_{real}$ is a largest one among the encoding code rate of the transport block, a code rate limit of the transport block, and a minimum code rate of the LDPC code. The second code rate $R_{min}$ is a minimum code rate corresponding to the maximum code block length of the LDPC code, or a larger one between a minimum code rate corresponding to the maximum code block length of the LDPC code and a code rate limit of the maximum code block length of the LDPC code.

In the foregoing steps, it is determined, based on relative values of the first code rate and the second code rate, how to calculate the quantity of code blocks into which the transport block is to be segmented, instead of directly calculating, based on the maximum code block length of the LDPC code, the quantity of code blocks into which the transport block is to be segmented. In the calculation process, a size of a buffer used by a receive end to store soft information of a code block is used, so that the quantity of code blocks obtained through calculation is more appropriate.

In an optional solution, if the first code rate $R_{real}$ is less than the second code rate $R_{min}$, the first determining unit 1002 is configured to determine, based on the first code rate $R_{real}$ and a maximum encoded length $N_{CB}$ of a code block, the quantity C of code blocks into which the transport block is to be segmented.

In another optional solution, the code rate limit of the maximum code block length of the LDPC code is $K_{max}/N_{CB,limit}$, and $N_{CB,limit}$ is a size of a buffer used by a receive end to store soft information of the code block.

In another optional solution, the code rate limit of the transport block is $(TBS + L_{TB,CRC})/N_{IR}$, TBS is a length of the transport block, $L_{TB,CRC}$ is a length of cyclic redundancy check CRC bits of the transport block, and $N_{IR}$ is a size of a buffer used by the receive end to store soft information of the transport block.

In another optional solution, that the first determining unit 1002 is configured to determine, based on a maximum code block length $K_{max}$ of an LDPC, a quantity of code blocks into which the transport block is to be segmented includes: determining, based on the maximum code block length $K_{max}$ of the LDPC, the quantity of code blocks into which the transport block is to be segmented, where a value of the quantity C of code blocks into which the transport block is to be segmented satisfies:

$$C = \left\lceil (TBS + L_{TB,CRC}) / \left( K_{max} - L_{CB,CRC} \right) \right\rceil,$$

where

TBS is the length of the transport block, $L_{TB,CRC}$ is the length of the CRC bits of the transport block, and $L_{CB,CRC}$ is a length of CRC bits of the code block.

In another optional solution, the determining, based on the first code rate and a maximum encoded length $N_{CB}$ of a code block, the quantity of code blocks into which the transport block is to be segmented includes: determining, based on the first code rate and the maximum encoded length $N_{CB}$ of the code block, the quantity of code blocks into which the transport block is to be segmented, where a value of the quantity C of code blocks into which the transport block is to be segmented satisfies:

$$C = \left\lfloor (TBS + L_{TB,CRC}) / \left( \lfloor R_{real} * N_{CB} \rfloor - L_{CB,CRC} \right) \right\rfloor,$$

or

$$C = \left\lceil (TBS + L_{TB,CRC}) / (\lfloor R_{real} * N_{CB} \rfloor - L_{CB,CRC}) \right\rceil,$$

where

TBS is the length of the transport block, $L_{TB,CRC}$ is the length of the CRC bits of the transport block, and $L_{CB,CRC}$ is a length of CRC bits of the code block.

In another optional solution, if a sum of the length of the transport block and the length of the CRC bits of the transport block is greater than the maximum code block length of the LDPC, and the following condition $(TBS + L_{TB,CRC})$mod $(\lfloor R_{real} * N_{CB} \rfloor - L_{CB,CRC}) < Th$ is satisfied, the value of C satisfies C = $\lfloor (TBS + L_{TB,CRC})/(\lfloor R_{real} * N_{CB} \rfloor - L_{CB,CRC}) \rfloor$, or

if a sum of the length of the transport block and the length of the CRC bits of the transport block is greater than the maximum code block length of the LDPC, and the following condition $(TBS + L_{TB,CRC})$mod $(\lfloor R_{real} * N_{CB} \rfloor - L_{CB,CRC}) \geq Th$ is satisfied, the value of C satisfies C = $\lceil (TBS + L_{TB,CRC})/(\lfloor R_{real} * N_{CB} \rfloor - L_{CB,CRC}) \rceil$, where
Th is a preset threshold.

In another optional solution, the preset threshold Th is less than or equal to a difference between the maximum code block length of the LDPC and a length of $\lfloor R_{real} * N_{CB} \rfloor$ and is greater than 0. It should be noted that, for implementations of the units, refer to the corresponding descriptions of the method embodiment shown in FIG. 4.

In the apparatus 100 in FIG. 10, it is determined, based on the relative values of the first code rate and the second code rate, how to calculate the quantity of code blocks into which the transport block is to be segmented, instead of directly calculating, based on the maximum code block length of the LDPC code, the quantity of code blocks into which the transport block is to be segmented. In the calculation process, the size of the buffer used by the receive end to store the soft information of the code block is used, so that the quantity of code blocks obtained through calculation is more appropriate.

FIG. 11 is a schematic structural diagram of an apparatus 110 according to an embodiment of the present invention. The apparatus 110 may include a fourth determining unit 1101 and a fifth determining unit 1102. Detailed descriptions of the units are as follows:

The fourth determining unit 1101 is configured to determine whether a length obtained by encoding a transport block based on $R_{min,K_{max}}$ is greater than or equal to a smaller value in $N_{IR}$ and G, where $R_{min,K_{max}}$ is a minimum code rate corresponding to a maximum code block length of an LDPC, $N_{IR}$ is a size of a buffer used by a receive end to store soft information of the transport block, and G is a quantity of authorized bits used to transmit the transport block. If the length obtained by encoding the transport block based on $R_{min,K_{max}}$ is greater than or equal to the smaller value in $N_{IR}$ and G, the fifth determining unit 1102 is configured to determine, based on the maximum code block length $K_{max}$ of the LDPC, a quantity of code blocks into which the transport block is to be segmented.

In the foregoing steps, an estimated length obtained by encoding the transport block is compared with a smaller value in a size of a buffer used by the receive end to store soft information of a code block and a quantity of bits that are authorized by a system and that are used to transmit the transport block. If the estimated length obtained by encoding the transport block is larger, the quantity of code blocks into which the transport block is to be segmented is determined based on the maximum code block length $K_{max}$ of the LDPC. If the estimated length obtained by encoding the transport block is smaller, the quantity of code blocks into which the transport block is to be segmented is determined based on a length of the transport block and a minimum code rate of the LDPC. In this process, the size of the buffer used by the receive end to store the soft information of the code block is considered, so that the quantity of code blocks obtained through calculation is more appropriate.

In an optional solution, if the length obtained by encoding the transport block based on $R_{min,K_{max}}$ is less than the smaller value in $N_{IR}$ and G, the fifth determining unit 1102 is configured to determine, based on a length of the transport block and a minimum code rate of the LDPC, the quantity of code blocks into which the transport block is to be segmented.

In another optional solution, that the fifth determining unit 1102 is configured to determine, based on a length of the transport block and a minimum code rate of the LDPC, the quantity of code blocks into which the transport block is to be segmented includes: determining, based on the length of the transport block and the minimum code rate of the LDPC, the quantity of code blocks into which the transport block is to be segmented, where a value of the quantity C of code blocks into which the transport block is to be segmented satisfies:

$$C = \left\lceil \min\left((TBS + L_{TB,CRC})/R_{min,K}, G, N_{IR}\right)/N_{CB} \right\rceil,$$

or

$$C = \left\lfloor \min\left((TBS + L_{TB,CRC})/R_{min,K}, G, N_{IR}\right)/N_{CB} \right\rfloor,$$

where

TBS is the length of the transport block, $L_{TB,CRC}$ is a length of cyclic redundancy check CRC bits of the transport block, $R_{min,K}$ is the minimum code rate of the LDPC, and $N_{CB}$ is a smaller value in a maximum encoded length $N_{max}$ of the LDPC code and a size of a buffer used by the receive end to store soft information of the code block.

In another optional solution, that the fifth determining unit 1102 is configured to determine, based on the maximum code block length $K_{max}$ of the LDPC, a quantity of code blocks into which the transport block is to be segmented includes: determining, based on the maximum code block length $K_{max}$ of the LDPC, the quantity of code blocks into which the transport block is to be segmented, where the value of the quantity C of code blocks into which the transport block is to be segmented satisfies:

$$C = \left\lceil (TBS + L_{TB,CRC})/\left(K_{max} - L_{CB,CRC}\right) \right\rceil,$$

where

TBS is the length of the transport block, $L_{TB,CRC}$ is the length of the cyclic redundancy check CRC bits of the transport block, and $L_{CB,CRC}$ is a length of CRC bits of the code block.

It should be noted that, for implementations of the units, refer to the corresponding descriptions of the method embodiment shown in FIG. 7.

In the apparatus 110 in FIG. 11, the estimated length obtained by encoding the transport block is compared with the smaller value in the size of the buffer used by the receive end to store the soft information of the code block and the quantity of bits that are authorized by the system and that are used to transmit the transport block. If the estimated length obtained by encoding the transport block is larger, the quantity of code blocks into which the transport block is to be segmented is determined based on the maximum code block length $K_{max}$ of the LDPC. If the estimated length obtained by encoding the transport block is smaller, the quantity of code blocks into which the transport block is to be segmented is determined based on the length of the transport block and the minimum code rate of the LDPC. In this process, the size of the buffer used by the receive end to store the soft information of the code block is considered, so that the quantity of code blocks obtained through calculation is more appropriate.

It may be understood that, the apparatuses (for example, the apparatus 80, the apparatus 90, the apparatus 100, and the apparatus 110) described in the foregoing embodiments may be one module or component. Therefore, the apparatus may be deployed in some devices. An embodiment of the present invention provides a device in which the apparatus is deployed. The device may determine a quantity of transport blocks based on the foregoing features of the apparatus.

In conclusion, in the embodiments of the present invention, it is determined, based on the relative values of the first code rate and the second code rate, how to calculate the quantity of code blocks into which the transport block is to be segmented, instead of directly calculating, based on the maximum code block length of the LDPC code, the quantity of code blocks into which the transport block is to be segmented. In the calculation process, the size of the buffer used by the receive end to store the soft information of the code block is used, so that the quantity of code blocks obtained through calculation is more appropriate.

A person of ordinary skill in the art can understand that all or some procedures in the methods in the foregoing embodiments may be implemented by a computer program instructing related hardware. The program may be stored in a computer readable storage medium. When the program is executed, the procedures of the foregoing method embodiments may be performed. The storage medium includes any medium that can store program code, such as a ROM, a random access memory RAM, a magnetic disk, or an optical disc.

## Claims

1. An information processing method, comprising:

   obtaining (S401) a current modulation and coding scheme, MCS, based on a current channel status;
   determine (S402), based on the obtained MCS, an encoding code rate of a transport block; and
   if a first code rate $R_{real}$ is greater than or equal to a second code rate $R_{min}$, determining (S404), based on a maximum code block length $K_{max}$ of an LDPC code, a quantity C of code blocks into which the transport block is to be segmented, wherein the first code rate $R_{real}$ is a largest one among the encoding code rate of the transport block, a code rate limit of the transport block, and a minimum code rate supported by the LDPC code,

$R_{min,K}$, wherein the code rate limit of the transport block is $(TBS + L_{TB,CRC})/N_{IR}$, TBS is a length of the transport block, $L_{TB,CRC}$ is a length of cyclic redundancy check, CRC, bits of the transport block, and $N_{IR}$ is a size of a buffer used by the receive end to store soft information of the transport block, and the second code rate $R_{min}$ is a minimum code rate corresponding to the maximum code block length of the LDPC code, or a larger one between a minimum code rate corresponding to the maximum code block length of the LDPC code and a code rate limit of the maximum code block length of the LDPC code, wherein the code rate limit of the maximum code block length of the LDPC code is $K_{max}/N_{CB,limit}$, and $N_{CB,limit}$ is a size of a buffer used by a receive end to store soft information of the code block.

2. The method according to claim 1, comprising: if the first code rate $R_{real}$ is less than the second code rate $R_{min}$, determining, based on the first code rate $R_{real}$ and a maximum encoded length $N_{CB}$ of a code block, the quantity C of code blocks into which the transport block is to be segmented, wherein

if the second code rate $R_{min}$ is the minimum code rate corresponding to the maximum code block length of the LDPC code, $N_{CB}$ is a maximum encoded length $N_{max}$ of the LDPC code; or
if the second code rate $R_{min}$ is the larger one between the minimum code rate corresponding to the maximum code block length of the LDPC code and the code rate limit of the maximum code block length of the LDPC code, $N_{CB}$ is $N_{CB,limit}$.

3. The method according to claim 1 or 2, wherein the determining, based on a maximum code block length $K_{max}$ of an LDPC, a quantity C of code blocks into which the transport block is to be segmented comprises: determining, based on the maximum code block length $K_{max}$ of the LDPC, the quantity C of code blocks into which the transport block is to be segmented, wherein a value of the quantity C of code blocks into which the transport block is to be segmented satisfies:

$$C = \left\lceil (TBS + L_{TB,CRC})/(K_{max} - L_{CB,CRC}) \right\rceil,$$

wherein
TBS is the length of the transport block, $L_{TB,CRC}$ is the length of the CRC bits of the transport block, and $L_{CB,CRC}$ is a length of CRC bits of the code block.

4. The method according to claim 2, wherein the determining, based on the first code rate $R_{real}$ and a maximum encoded length $N_{CB}$ of a code block, the quantity of code blocks into which the transport block is to be segmented comprises: determining, based on the first code rate $R_{real}$ and the maximum encoded length $N_{CB}$ of the code block, the quantity of code blocks into which the transport block is to be segmented, wherein a value of the quantity C of code blocks into which the transport block is to be segmented satisfies:

$$C = \left\lfloor (TBS + L_{TB,CRC})/(\lfloor R_{real} * N_{CB} \rfloor - L_{CB,CRC}) \right\rfloor,$$

or

$$C = \left\lceil (TBS + L_{TB,CRC})/(\lfloor R_{real} * N_{CB} \rfloor - L_{CB,CRC}) \right\rceil,$$

wherein
TBS is the length of the transport block, $L_{TB,CRC}$ is the length of the CRC bits of the transport block, and $L_{CB,CRC}$ is a length of CRC bits of the code block.

5. The method according to claim 4, wherein if a sum of the length of the transport block and the length of the CRC bits of the transport block is greater than the maximum code block length of the LDPC, and the following condition $(TBS + L_{TB,CRC}) \bmod (\lfloor R_{real} * N_{CB} \rfloor - L_{CB,CRC}) < Th$ is satisfied, the value of C satisfies $C = \lfloor (TBS + L_{TB,CRC})/(\lfloor R_{real} * N_{CB} \rfloor - L_{CB,CRC}) \rfloor$, or

if a sum of the length of the transport block and the length of the CRC bits of the transport block is greater than the maximum code block length of the LDPC, and the following condition $(TBS + L_{TB,CRC}) \bmod (\lfloor R_{real} * N_{CB} \rfloor - L_{CB,CRC}) \geq Th$ is satisfied, the value of C satisfies $C = \lfloor (TBS + L_{TB,CRC})/(\lfloor R_{real} * N_{CB} \rfloor - L_{CB,CRC}) \rceil$, wherein

Th is a preset threshold, and the preset threshold Th is less than or equal to a difference between the maximum code block length of the LDPC and a length of $\lfloor R_{real} * N_{CB} \rfloor$ and is greater than 0.

6.  An information processing apparatus (80), wherein the apparatus (80) comprises a processor (801) and a memory (803), the memory (803) is configured to store a transport block, and the processor (801) is configured to perform the following operations:

    obtaining a current modulation and coding scheme, MCS, based on a current channel status;
    determining, based on the obtained MCS, an encoding code rate of the transport block; and
    if a first code rate $R_{real}$ is greater than or equal to a second code rate $R_{min}$, determining, based on a maximum code block length $K_{max}$ of an LDPC, a quantity C of code blocks into which the transport block is to be segmented, wherein the first code rate $R_{real}$ is a largest one among the encoding code rate of the transport block, a code rate limit of the transport block, and a minimum code rate supported by the LDPC code, $R_{min,K}$, wherein the code rate limit of the transport block is $(TBS + L_{TB,CRC})/N_{IR}$, TBS is a length of the transport block, $L_{TB,CRC}$ is a length of cyclic redundancy check, CRC, bits of the transport block, and $N_{IR}$ is a size of a buffer used by the receive end to store soft information of the transport block, and the second code rate $R_{min}$ is a minimum code rate corresponding to the maximum code block length of the LDPC code, or a larger one between a minimum code rate corresponding to the maximum code block length of the LDPC code and a code rate limit of the maximum code block length of the LDPC code, wherein the code rate limit of the maximum code block length of the LDPC code is $K_{max}/N_{CB,limit}$, and $N_{CB,limit}$ is a size of a buffer used by a receive end to store soft information of the code block.

7.  The apparatus (80) according to claim 6, wherein if the first code rate $R_{real}$ is less than the second code rate $R_{min}$, the processor (801) is configured to determine, based on the first code rate $R_{real}$ and a maximum encoded length $N_{CB}$ of a code block, the quantity C of code blocks into which the transport block is to be segmented, wherein

    if the second code rate $R_{min}$ is the minimum code rate corresponding to the maximum code block length of the LDPC code, $N_{CB}$ is a maximum encoded length $N_{max}$ of the LDPC code; or
    if the second code rate $R_{min}$ is the larger one between the minimum code rate corresponding to the maximum code block length of the LDPC code and the code rate limit of the maximum code block length of the LDPC code, $N_{CB}$ is $N_{CB,limit}$.

8.  The apparatus (80) according to claim 6 or 7, wherein the processor (801) is configured to determine, based on the maximum code block length $K_{max}$ of the LDPC, the quantity of code blocks into which the transport block is to be segmented, wherein a value of the quantity C of code blocks into which the transport block is to be segmented satisfies:

$$C = \left\lceil (TBS + L_{TB,CRC})/\left( K_{max} - L_{CB,CRC} \right) \right\rceil,$$

wherein
TBS is the length of the transport block, $L_{TB,CRC}$ is the length of the CRC bits of the transport block, and $L_{CB,CRC}$ is a length of CRC bits of the code block.

9.  The apparatus (80) according to any one of claims 6 to 8, wherein the processor (801) is configured to determine, based on the first code rate and the maximum encoded length $N_{CB}$ of the code block, the quantity of code blocks into which the transport block is to be segmented, wherein a value of the quantity C of code blocks into which the transport block is to be segmented satisfies:

$$C = \left\lfloor (TBS + L_{TB,CRC})/\left( \lfloor R_{real} * N_{CB} \rfloor - L_{CB,CRC} \right) \right\rfloor,$$

or

$$C = \left\lceil (TBS + L_{TB,CRC})/\left( \lfloor R_{real} * N_{CB} \rfloor - L_{CB,CRC} \right) \right\rceil,$$

wherein
TBS is the length of the transport block, $L_{TB,CRC}$ is the length of the CRC bits of the transport block, and $L_{CB,CRC}$

is a length of CRC bits of the code block.

**10.** The apparatus according to claim 9, wherein

if a sum of the length of the transport block and the length of the CRC bits of the transport block is greater than the maximum code block length of the LDPC, and the following condition *(TBS + L$_{TB,CRC}$)*mod ($\lfloor R_{real}$ * $N_{CB}\rfloor$ - L$_{CB,CRC}$) < *Th* is satisfied, the value of C satisfies C = $\lfloor$*(TBS + L$_{TB,CRC}$)/($\lfloor R_{real}$ * $N_{CB}\rfloor$ - L$_{CB,CRC}$)$\rfloor$, or

if a sum of the length of the transport block and the length of the CRC bits of the transport block is greater than the maximum code block length of the LDPC, and the following condition *(TBS + L$_{TB,CRC}$)*mod ($\lfloor R_{real}$ * $N_{CB}\rfloor$ - L$_{CB,CRC}$) $\geq$ *Th* is satisfied, the value of C satisfies C = $\lfloor$*(TBS + L$_{TB,CRC}$)/($\lfloor R_{real}$ * $N_{CB}\rfloor$ - L$_{CB,CRC}$)$\rceil$, wherein Th is a preset threshold, and the preset threshold Th is less than or equal to a difference between the maximum code block length of the LDPC and a length of $\lfloor R_{real}$ * $N_{CB}\rfloor$ and is greater than 0.

**11.** A communications device, wherein the communications device comprises the information processing apparatus according to any one of claims 6 to 10.

**Patentansprüche**

**1.** Informationsverarbeitungsverfahren, das Folgendes umfasst:

Erhalten (S401) eines aktuellen Modulations- und Codierungsschemas, MCS, basierend auf einem aktuellen Kanalzustand;

Bestimmen (S402) einer Codierungscoderate eines Transportblocks basierend auf dem erhaltenen MCS; und, wenn eine erste Coderate $R_{real}$ größer als oder gleich einer zweiten Coderate $R_{min}$ ist, Bestimmen (S404) einer Menge C von Codeblöcken, in die der Transportblock aufzuteilen ist, basierend auf einer maximalen Codeblocklänge K$_{max}$ eines LDPC-Codes, wobei die erste Coderate $R_{real}$ die größte unter der Codierungscoderate des Transportblocks, einer Grenzwertcoderate des Transportblocks und einer vom LDPC-Code unterstützten minimalen Coderate, $R_{min,K}$, ist, wobei die Grenzwertcoderate des Transportblocks *(TBS + L$_{TB,CRC}$)/N$_{IR}$* ist, wobei *TBS* eine Länge des Transportblocks, *L$_{TB,CRC}$* eine Länge von Bits einer zyklischen Redundanzüberprüfung, CRC-Bits, des Transportblocks und *N$_{IR}$* eine Größe eines vom Empfangsende zum Speichern weicher Informationen des Transportblocks genutzten Puffers ist, und die zweite Coderate $R_{min}$ eine minimale Coderate, die mit der maximalen Codeblocklänge des LDPC-Codes korrespondiert, oder eine größere zwischen einer minimalen Coderate, die mit der maximalen Codeblocklänge des LDPC-Codes korrespondiert, und einer Grenzwertcoderate der maximalen Codeblocklänge des LDPC-Codes ist, wobei die Grenzwertcoderate der maximalen Codeblocklänge des LDPC-Codes *K$_{max}$/N$_{CB,limit}$* ist, wobei *N$_{CB,limit}$* eine Größe eines von einem Empfangsende zum Speichern weicher Informationen des Codeblocks genutzten Puffers ist.

**2.** Verfahren nach Anspruch 1, das Folgendes umfasst: wenn die erste Coderate $R_{real}$ kleiner als die zweite Coderate $R_{min}$ ist, Bestimmen der Menge C von Codeblöcken, in die der Transportblock aufzuteilen ist, basierend auf der ersten Coderate $R_{real}$ und einer maximalen codierten Länge $N_{CB}$ eines Codeblocks, wobei,

wenn die zweite Coderate $R_{min}$ die minimale Coderate, die mit der maximalen Codeblocklänge des LDPC-Codes korrespondiert, ist, $N_{CB}$ dann eine maximale codierte Länge N$_{max}$ des LDPC-Codes ist; oder, wenn die zweite Coderate $R_{min}$ die größere zwischen der minimalen Coderate, die mit der maximalen Codeblocklänge des LDPC-Codes korrespondiert, und der Grenzwertcoderate der maximalen Codeblocklänge des LDPC-Codes ist, $N_{CB}$ dann $N_{CB,limit}$ ist.

**3.** Verfahren nach Anspruch 1 oder 2, wobei das Bestimmen einer Menge C von Codeblöcken, in die der Transportblock aufzuteilen ist, basierend auf einer maximalen Codeblocklänge K$_{max}$ eines LDPC Folgendes umfasst: Bestimmen der Menge C von Codeblöcken, in die der Transportblock aufzuteilen ist, basierend auf der maximalen Codeblocklänge K$_{max}$ des LDPC, wobei ein Wert der Menge C von Codeblöcken, in die der Transportblock aufzuteilen ist, Folgendes erfüllt:

$$C = \lceil (TBS + L_{TB,CRC})/(K_{max} - L_{CB,CRC}) \rceil,$$

wobei

*TBS* die Länge des Transportblocks, $L_{TB,CRC}$ die Länge der CRC-Bits des Transportblocks und $L_{CB,CRC}$ eine Länge von CRC-Bits des Codeblocks ist.

4. Verfahren nach Anspruch 2, wobei das Bestimmen der Menge von Codeblöcken, in die der Transportblock aufzuteilen ist, basierend auf der ersten Coderate $R_{real}$ und einer maximalen codierten Länge $N_{CB}$ eines Codeblocks Folgendes umfasst: Bestimmen der Menge von Codeblöcken, in die der Transportblock aufzuteilen ist, basierend auf der ersten Coderate $R_{real}$ und der maximalen codierten Länge $N_{CB}$ des Codeblocks, wobei ein Wert der Menge C von Codeblöcken, in die der Transportblock aufzuteilen ist, Folgendes erfüllt:

$$C = \lfloor (TBS + L_{TB,CRC})/(\lfloor R_{real} \times N_{CB} \rfloor - L_{CB,CRC}) \rfloor$$

oder

$$C = \lceil (TBS + L_{TB,CRC})/(\lfloor R_{real} \times N_{CB} \rfloor - L_{CB,CRC}) \rceil,$$

wobei
*TBS* die Länge des Transportblocks, $L_{TB,CRC}$ die Länge der CRC-Bits des Transportblocks und $L_{CB,CRC}$ eine Länge von CRC-Bits des Codeblocks ist.

5. Verfahren nach Anspruch 4, wobei, wenn eine Summe der Länge des Transportblocks und der Länge der CRC-Bits des Transportblocks größer als die maximale Codeblocklänge des LDPC ist und die folgende Bedingung $(TBS + L_{TB,CRC})$mod $(\lfloor R_{real} \times N_{CB} \rfloor - L_{CB,CRC}) < Th$ erfüllt ist, der Wert von C dann C = $\lfloor (TBS + L_{TB,CRC})/(\lfloor R_{real} \times N_{CB} \rfloor - L_{CB,CRC}) \rfloor$ erfüllt oder, wenn eine Summe der Länge des Transportblocks und der Länge der CRC-Bits des Transportblocks größer als die maximale Codeblocklänge des LDPC ist und die folgende Bedingung $(TBS + L_{TB,CRC})$mod $(\lfloor R_{real} \times N_{CB} \rfloor - L_{CB,CRC})$ $\geq Th$ erfüllt ist, der Wert von C dann C = $\lceil (TBS + L_{TB,CRC})/(\lfloor R_{real} \times N_{CB} \rfloor - L_{CB,CRC}) \rceil$ erfüllt, wobei *Th* ein voreingestellter Schwellenwert ist und der voreingestellte Schwellenwert *Th* kleiner als oder gleich einer Differenz zwischen der maximalen Codeblocklänge des LDPC und einer Länge aus $\lfloor R_{real} \times N_{CB} \rfloor$ und größer als 0 ist.

6. Informationsverarbeitungsvorrichtung (80), wobei die Vorrichtung (80) einen Prozessor (801) und einen Speicher (803) umfasst, der Speicher (803) konfiguriert ist, um einen Transportblock zu speichern, und der Prozessor (801) konfiguriert ist, um folgende Vorgänge durchzuführen:

Erhalten eines aktuellen Modulations- und Codierungsschemas, MCS, basierend auf einem aktuellen Kanalzustand;
Bestimmen einer Codierungscoderate des Transportblocks basierend auf dem erhaltenen MCS; und,
wenn eine erste Coderate $R_{real}$ größer als oder gleich einer zweiten Coderate $R_{min}$ ist, Bestimmen einer Menge C von Codeblöcken, in die der Transportblock aufzuteilen ist, basierend auf einer maximalen Codeblocklänge $K_{max}$ eines LDPC, wobei die erste Coderate $R_{real}$ die größte unter der Codierungscoderate des Transportblocks, einer Grenzwertcoderate des Transportblocks und einer vom LDPC-Code unterstützten minimalen Coderate, $R_{min,K}$, ist, wobei die Grenzwertcoderate des Transportblocks $(TBS + L_{TB,CRC})/N_{IR}$ ist, wobei *TBS* eine Länge des Transportblocks, $L_{TB,CRC}$ eine Länge von Bits einer zyklischen Redundanzüberprüfung, CRC-Bits, des Transportblocks und $N_{IR}$ eine Größe eines vom Empfangsende zum Speichern weicher Informationen des Transportblocks genutzten Puffers ist, und die zweite Coderate $R_{min}$ eine minimale Coderate, die mit der maximalen Codeblocklänge des LDPC-Codes korrespondiert, oder eine größere zwischen einer minimalen Coderate, die mit der maximalen Codeblocklänge des LDPC-Codes korrespondiert, und einer Grenzwertcoderate der maximalen Codeblocklänge des LDPC-Codes ist, wobei die Grenzwertcoderate der maximalen Codeblocklänge des LDPC-Codes $K_{max}/N_{CB,limit}$ ist, wobei $N_{CB,limit}$ eine Größe eines von einem Empfangsende zum Speichern weicher Informationen des Codeblocks genutzten Puffers ist.

7. Vorrichtung (80) nach Anspruch 6, wobei, wenn die erste Coderate $R_{real}$ kleiner als die zweite Coderate $R_{min}$ ist, der Prozessor (801) konfiguriert ist, um basierend auf der ersten Coderate $R_{real}$ und einer maximalen codierten Länge $N_{CB}$ eines Codeblocks die Menge C von Codeblöcken, in die der Transportblock aufzuteilen ist, zu bestimmen, wobei,

wenn die zweite Coderate $R_{min}$ die minimale Coderate, die mit der maximalen Codeblocklänge des LDPC-Codes korrespondiert, ist, $N_{CB}$ dann eine maximale codierte Länge $N_{max}$ des LDPC-Codes ist; oder, wenn die zweite Coderate $R_{min}$ die größere zwischen der minimalen Coderate, die mit der maximalen Codeblocklänge des LDPC-Codes korrespondiert, und der Grenzwertcoderate der maximalen Codeblocklänge des LDPC-Codes ist, $N_{CB}$ dann $N_{CB,limit}$ ist.

**8.** Vorrichtung (80) nach Anspruch 6 oder 7, wobei der Prozessor (801) konfiguriert ist, um basierend auf der maximalen Codeblocklänge $K_{max}$ des LDPC die Menge von Codeblöcken, in die der Transportblock aufzuteilen ist, zu bestimmen, wobei ein Wert der Menge C von Codeblöcken, in die der Transportblock aufzuteilen ist, Folgendes erfüllt:

$$C = \lceil (TBS + L_{TB,CRC})/(K_{max} - L_{CB,CRC}) \rceil,$$

wobei

$TBS$ die Länge des Transportblocks, $L_{TB,CRC}$ die Länge der CRC-Bits des Transportblocks und $L_{CB,CRC}$ eine Länge von CRC-Bits des Codeblocks ist.

**9.** Vorrichtung (80) nach einem der Ansprüche 6 bis 8, wobei der Prozessor (801) konfiguriert ist, um basierend auf der ersten Coderate und der maximalen codierten Länge $N_{CB}$ des Codeblocks die Menge von Codeblöcken, in die der Transportblock aufzuteilen ist, zu bestimmen, wobei ein Wert der Menge C von Codeblöcken, in die der Transportblock aufzuteilen ist, Folgendes erfüllt:

$$C = \lfloor (TBS + L_{TB,CRC})/(\lfloor R_{real} \times N_{CB} \rfloor - L_{CB,CRC}) \rfloor$$

oder

$$C = \lceil (TBS + L_{TB,CRC})/(\lfloor R_{real} \times N_{CB} \rfloor - L_{CB,CRC}) \rceil,$$

wobei

$TBS$ die Länge des Transportblocks, $L_{TB,CRC}$ die Länge der CRC-Bits des Transportblocks und $L_{CB,CRC}$ eine Länge von CRC-Bits des Codeblocks ist.

**10.** Vorrichtung nach Anspruch 9, wobei, wenn eine Summe der Länge des Transportblocks und der Länge der CRC-Bits des Transportblocks größer als die maximale Codeblocklänge des LDPC ist und die folgende Bedingung $(TBS + L_{TB,CRC})\bmod (\lfloor R_{real} \times N_{CB} \rfloor - L_{CB,CRC})$ $< Th$ erfüllt ist, der Wert von C dann $C = \lfloor (TBS + L_{TB,CRC})/(\lfloor R_{real} \times N_{CB} \rfloor - L_{CB,CRC}) \rfloor$ erfüllt oder, wenn eine Summe der Länge des Transportblocks und der Länge der CRC-Bits des Transportblocks größer als die maximale Codeblocklänge des LDPC ist und die folgende Bedingung $(TBS + L_{TB,CRC})\bmod (\lfloor R_{real} \times N_{CB} \rfloor - L_{CB,CRC}) \geq Th$ erfüllt ist, der Wert von C dann $C = \lceil (TBS + L_{TB,CRC})/(\lfloor R_{real} \times N_{CB} \rfloor - L_{CB,CRC}) \rceil$ erfüllt, wobei $Th$ ein voreingestellter Schwellenwert ist und der voreingestellte Schwellenwert $Th$ kleiner als oder gleich einer Differenz zwischen der maximalen Codeblocklänge des LDPC und einer Länge aus $\lfloor R_{real} \times N_{CB} \rfloor$ und größer als 0 ist.

**11.** Kommunikationsgerät, wobei das Kommunikationsgerät die Informationsverarbeitungsvorrichtung nach einem der Ansprüche 6 bis 10 umfasst.

**Revendications**

**1.** Procédé de traitement d'informations, comprenant :

l'obtention (S401) d'un schéma de modulation et de codage, MCS, actuel sur la base d'un état de canal actuel ;
la détermination (S402), sur la base du MCS obtenu, d'un débit de code d'encodage d'un bloc de transport ; et
si un premier débit de code $R_{real}$ est supérieur ou égal à un second débit de code $R_{min}$, la détermination (S404), sur la base d'une longueur de bloc de code maximum $K_{max}$ d'un code LDPC, d'une quantité C de blocs de code en lesquels le bloc de transport doit être segmenté, dans lequel le premier débit de code $R_{real}$ est un plus grand parmi le débit de code d'encodage du bloc de transport, une limite de débit de code du bloc de transport, et un débit de code minimum pris en charge par le code LDPC, $R_{min,K}$, dans lequel la limite de débit de code du bloc de transport est *(TBS + $L_{TB,CRC}$)/$N_{IR}$*, TBS est une longueur du bloc de transport, $L_{TB,CRC}$ est une longueur de bits de contrôle de redondance cyclique, CRC, du bloc de transport, et $N_{IR}$ est une taille d'une mémoire tampon utilisée par l'extrémité de réception pour stocker des informations souples du bloc de transport, et le second débit de code $R_{min}$ est un débit de code minimum correspondant à la longueur de bloc de code maximum du code LDPC, ou un plus grand entre un débit de code minimum correspondant à la longueur de bloc de code maximum du code LDPC et une limite de débit de code de la longueur de bloc de code maximum du code LDPC, dans lequel la limite de débit de code de la longueur de bloc de code maximum du code LDPC est $K_{max}$/$N_{CB,limit}$, et $N_{CB,limit}$ est une taille d'une mémoire tampon utilisée par une extrémité de réception pour stocker des informations souples du bloc de code.

2. Procédé selon la revendication 1, comprenant : si le premier débit de code $R_{real}$ est inférieur au second débit de code $R_{min}$, la détermination, sur la base du premier débit de code $R_{real}$ et d'une longueur encodée maximum $N_{CB}$ d'un bloc de code, de la quantité C de blocs de code en lesquels le bloc de transport doit être segmenté, dans lequel

   si le second débit de code $R_{min}$ est le débit de code minimum correspondant à la longueur de bloc de code maximum du code LDPC, $N_{CB}$ est une longueur encodée maximum $N_{max}$ du code LDPC ; ou
   si le second débit de code $R_{min}$ est le plus grand entre le débit de code minimum correspondant à la longueur de bloc de code maximum du code LDPC et la limite de débit de code de la longueur de bloc de code maximum du code LDPC, $N_{CB}$ est $N_{CB,limit}$.

3. Procédé selon la revendication 1 ou 2, dans lequel la détermination, sur la base d'une longueur de bloc de code maximum Kmax d'un LDPC, d'une quantité C de blocs de code en lesquels le bloc de transport doit être segmenté comprend : la détermination, sur la base de la longueur de bloc de code maximum $K_{max}$ du LDPC, de la quantité C de blocs de code en lesquels le bloc de transport doit être segmenté, dans lequel une valeur de la quantité C de blocs de code en lesquels le bloc de transport doit être segmenté respecte :

$$C = \lceil(TBS + L_{TB,CRC})/(K_{max} - L_{CB,CRC})\rceil,$$

   dans lequel
   TBS est la longueur du bloc de transport, $L_{TB,CRC}$ est la longueur des bits de CRC du bloc de transport, et $L_{CB,CRC}$ est une longueur de bits de CRC du bloc de code.

4. Procédé selon la revendication 2, dans lequel la détermination, sur la base du premier débit de code $R_{real}$ et d'une longueur encodée maximum $N_{CB}$ d'un bloc de code, de la quantité de blocs de code en lesquels le bloc de transport doit être segmenté comprend : la détermination, sur la base du premier débit de code $R_{real}$ et de la longueur encodée maximum $N_{CB}$ du bloc de code, de la quantité de blocs de code en lesquels le bloc de transport doit être segmenté, dans lequel une valeur de la quantité C de blocs de code en lesquels le bloc de transport doit être segmenté respecte :

$$C = \lfloor(TBS + L_{TB,CRC})/(\lfloor R_{real} * N_{CB}\rfloor - L_{CB,CRC})\rfloor,$$

   ou

$$C = \lceil(TBS + L_{TB,CRC})/(\lfloor R_{real} * N_{CB}\rfloor - L_{CB,CRC})\rceil,$$

   dans lequel
   TBS est la longueur du bloc de transport, $L_{TB,CRC}$ est la longueur des bits de CRC du bloc de transport, et $L_{CB,CRC}$ est une longueur de bits de CRC du bloc de code.

5. Procédé selon la revendication 4, dans lequel, si une somme de la longueur du bloc de transport et de la longueur des bits de CRC du bloc de transport est supérieure à la longueur de bloc de code maximum du LDPC, et la condition suivante *(TBS + $L_{TB,CRC}$)*mod ($\lfloor R_{real} * N_{CB}\rfloor$ - $L_{CB,CRC}$) < *Th* est respectée, la valeur de C respecte

$$C = \lfloor(TBS + L_{TB,CRC})/(\lfloor R_{real} * N_{CB}\rfloor - L_{CB,CRC})\rfloor,$$

ou

si une somme de la longueur du bloc de transport et de la longueur des bits de CRC du bloc de transport est supérieure à la longueur de bloc de code maximum du LDPC, et la condition suivante $(TBS + L_{TB,CRC})\bmod (\lfloor R_{real} * N_{CB}\rfloor - L_{CB,CRC}) \geq Th$ est respectée, la valeur de C respecte $C= \lceil(TBS + L_{TB,CRC})/(\lfloor R_{real} * N_{CB}\rfloor - L_{CB,CRC})\rceil$, dans lequel

Th est un seuil prédéterminé, et le seuil prédéterminé Th est inférieur ou égal à une différence entre la longueur de bloc de code maximum du LDPC et une longueur de $\lfloor R_{real} * N_{CB}\rfloor$ et est supérieur à 0.

6. Appareil de traitement d'informations (80), l'appareil (80) comprenant un processeur (801) et une mémoire (803), la mémoire (803) étant configurée pour stocker un bloc de transport, et le processeur (801) étant configuré pour réaliser les opérations suivantes :

   l'obtention d'un schéma de modulation et de codage, MCS, actuel sur la base d'un état de canal actuel ;
   la détermination, sur la base du MCS obtenu, d'un débit de code d'encodage du bloc de transport ; et
   si un premier débit de code $R_{real}$ est supérieur ou égal à un second débit de code $R_{min}$, la détermination, sur la base d'une longueur de bloc de code maximum $K_{max}$ d'un LDPC, d'une quantité C de blocs de code en lesquels le bloc de transport doit être segmenté, dans lequel le premier débit de code $R_{real}$ est un plus grand parmi le débit de code d'encodage du bloc de transport, une limite de débit de code du bloc de transport, et un débit de code minimum pris en charge par le code LDPC, $R_{min,K}$, dans lequel la limite de débit de code du bloc de transport est $(TBS + L_{TB,CRC})/N_{IR}$, TBS est une longueur du bloc de transport, $L_{TB,CRC}$ est une longueur de bits de contrôle de redondance cyclique, CRC, du bloc de transport, et $N_{IR}$ est une taille d'une mémoire tampon utilisée par l'extrémité de réception pour stocker des informations souples du bloc de transport, et le second débit de code $R_{min}$ est un débit de code minimum correspondant à la longueur de bloc de code maximum du code LDPC, ou un plus grand entre un débit de code minimum correspondant à la longueur de bloc de code maximum du code LDPC et une limite de débit de code de la longueur de bloc de code maximum du code LDPC, dans lequel la limite de débit de code de la longueur de bloc de code maximum du code LDPC est $K_{max}/N_{CB,limit}$, et $N_{CB,limit}$ est une taille d'une mémoire tampon utilisée par une extrémité de réception pour stocker des informations souples du bloc de code.

7. Appareil (80) selon la revendication 6, dans lequel, si le premier débit de code $R_{real}$ est inférieur au second débit de code $R_{min}$, le processeur (801) est configuré pour déterminer, sur la base du premier débit de code $R_{real}$ et d'une longueur encodée maximum $N_{CB}$ d'un bloc de code, la quantité C de blocs de code en lesquels le bloc de transport doit être segmenté, dans lequel

   si le second débit de code $R_{min}$ est le débit de code minimum correspondant à la longueur de bloc de code maximum du code LDPC, $N_{CB}$ est une longueur encodée maximum $N_{max}$ du code LDPC ; ou
   si le second débit de code $R_{min}$ est le plus grand entre le débit de code minimum correspondant à la longueur de bloc de code maximum du code LDPC et la limite de débit de code de la longueur de bloc de code maximum du code LDPC, $N_{CB}$ est $N_{CB,limit}$.

8. Appareil (80) selon la revendication 6 ou 7, dans lequel le processeur (801) est configuré pour déterminer, sur la base de la longueur de bloc de code maximum $K_{max}$ du LDPC, la quantité de blocs de code en lesquels le bloc de transport doit être segmenté, dans lequel une valeur de la quantité C de blocs de code en lesquels le bloc de transport doit être segmenté respecte :

$$C = \lceil(TBS + L_{TB,CRC})/(K_{max} - L_{CB,CRC})\rceil,$$

dans lequel
TBS est la longueur du bloc de transport, $L_{TB,CRC}$ est la longueur des bits de CRC du bloc de transport, et $L_{CB,CRC}$ est une longueur de bits de CRC du bloc de code.

9. Appareil (80) selon l'une quelconque des revendications 6 à 8, dans lequel le processeur (801) est configuré pour déterminer, sur la base du premier débit de code et de la longueur encodée maximum $N_{CB}$ du bloc de code, la quantité de blocs de code en lesquels le bloc de transport doit être segmenté, dans lequel une valeur de la quantité C de blocs de code en lesquels le bloc de transport doit être segmenté respecte :

$$C = \left\lfloor (TBS + L_{TB,CRC})/(\lfloor R_{real} * N_{CB} \rfloor - L_{CB,CRC}) \right\rfloor,$$

ou

$$C = \left\lceil (TBS + L_{TB,CRC})/(\lfloor R_{real} * N_{CB} \rfloor - L_{CB,CRC}) \right\rceil,$$

dans lequel
TBS est la longueur du bloc de transport, $L_{TB,CRC}$ est la longueur des bits de CRC du bloc de transport, et $L_{CB,CRC}$ est une longueur de bits de CRC du bloc de code.

**10.** Appareil selon la revendication 9, dans lequel

si une somme de la longueur du bloc de transport et de la longueur des bits de CRC du bloc de transport est supérieure à la longueur de bloc de code maximum du LDPC, et la condition suivante $(TBS + L_{TB,CRC})\mathrm{mod}$ $(\lfloor R_{real} * N_{CB} \rfloor - L_{CB,CRC}) < Th$ est respectée, la valeur de C respecte $C = \lfloor (TBS + L_{TB,CRC})/(\lfloor R_{real} * N_{CB} \rfloor - L_{CB,CRC}) \rfloor$, ou
si une somme de la longueur du bloc de transport et de la longueur des bits de CRC du bloc de transport est supérieure à la longueur de bloc de code maximum du LDPC, et la condition suivante $(TBS + L_{TB,CRC})\mathrm{mod}$ $(\lfloor R_{real} * N_{CB} \rfloor - L_{CB,CRC}) \geq Th$ est respectée, la valeur de C respecte $C = \lceil (TBS + L_{TB,CRC})/(\lfloor R_{real} * N_{CB} \rfloor - L_{CB,CRC}) \rceil$, dans lequel
Th est un seuil prédéterminé, et le seuil prédéterminé Th est inférieur ou égal à une différence entre la longueur de bloc de code maximum du LDPC et une longueur de $\lfloor R_{real} * N_{CB} \rfloor$ et est supérieur à 0.

**11.** Dispositif de communication, le dispositif de communication comprenant l'appareil de traitement d'informations selon l'une quelconque des revendications 6 à 10.

FIG. 1

| i | K | $f_1$ | $f_2$ | i | K | $f_1$ | $f_2$ | i | K | $f_1$ | $f_2$ | i | K | $f_1$ | $f_2$ |
|---|---|---|---|---|---|---|---|---|---|---|---|---|---|---|---|
| 1 | 40 | 3 | 10 | 48 | 416 | 25 | 52 | 95 | 1120 | 67 | 140 | 142 | 3200 | 111 | 240 |
| 2 | 48 | 7 | 12 | 49 | 424 | 51 | 106 | 96 | 1152 | 35 | 72 | 143 | 3264 | 443 | 204 |
| 3 | 56 | 19 | 42 | 50 | 432 | 47 | 72 | 97 | 1184 | 19 | 74 | 144 | 3328 | 51 | 104 |
| 4 | 64 | 7 | 16 | 51 | 440 | 91 | 110 | 98 | 1216 | 39 | 76 | 145 | 3392 | 51 | 212 |
| 5 | 72 | 7 | 18 | 52 | 448 | 29 | 168 | 99 | 1248 | 19 | 78 | 146 | 3456 | 451 | 192 |
| 6 | 80 | 11 | 20 | 53 | 456 | 29 | 114 | 100 | 1280 | 199 | 240 | 147 | 3520 | 257 | 220 |
| 7 | 88 | 5 | 22 | 54 | 464 | 247 | 58 | 101 | 1312 | 21 | 82 | 148 | 3584 | 57 | 336 |
| 8 | 96 | 11 | 24 | 55 | 472 | 29 | 118 | 102 | 1344 | 211 | 252 | 149 | 3648 | 313 | 228 |
| 9 | 104 | 7 | 26 | 56 | 480 | 89 | 180 | 103 | 1376 | 21 | 86 | 150 | 3712 | 271 | 232 |
| 10 | 112 | 41 | 84 | 57 | 488 | 91 | 122 | 104 | 1408 | 43 | 88 | 151 | 3776 | 179 | 236 |
| 11 | 120 | 103 | 90 | 58 | 496 | 157 | 62 | 105 | 1440 | 149 | 60 | 152 | 3840 | 331 | 120 |
| 12 | 128 | 15 | 32 | 59 | 504 | 55 | 84 | 106 | 1472 | 45 | 92 | 153 | 3904 | 363 | 244 |
| 13 | 136 | 9 | 34 | 60 | 512 | 31 | 64 | 107 | 1504 | 49 | 846 | 154 | 3968 | 375 | 248 |
| 14 | 144 | 17 | 108 | 61 | 528 | 17 | 66 | 108 | 1536 | 71 | 48 | 155 | 4032 | 127 | 168 |
| 15 | 152 | 9 | 38 | 62 | 544 | 35 | 68 | 109 | 1568 | 13 | 28 | 156 | 4096 | 31 | 64 |
| 16 | 160 | 21 | 120 | 63 | 560 | 227 | 420 | 110 | 1600 | 17 | 80 | 157 | 4160 | 33 | 130 |
| 17 | 168 | 101 | 84 | 64 | 576 | 65 | 96 | 111 | 1632 | 25 | 102 | 158 | 4224 | 43 | 264 |
| 18 | 176 | 21 | 44 | 65 | 592 | 19 | 74 | 112 | 1664 | 183 | 104 | 159 | 4288 | 33 | 134 |
| 19 | 184 | 57 | 46 | 66 | 608 | 37 | 76 | 113 | 1696 | 55 | 954 | 160 | 4352 | 477 | 408 |
| 20 | 192 | 23 | 48 | 67 | 624 | 41 | 234 | 114 | 1728 | 127 | 96 | 161 | 4416 | 35 | 138 |
| 21 | 200 | 13 | 50 | 68 | 640 | 39 | 80 | 115 | 1760 | 27 | 110 | 162 | 4480 | 233 | 280 |
| 22 | 208 | 27 | 52 | 69 | 656 | 185 | 82 | 116 | 1792 | 29 | 112 | 163 | 4544 | 357 | 142 |
| 23 | 216 | 11 | 36 | 70 | 672 | 43 | 252 | 117 | 1824 | 29 | 114 | 164 | 4608 | 337 | 480 |

| | | | | | | | | | | | | | | | |
|---|---|---|---|---|---|---|---|---|---|---|---|---|---|---|---|
| 24 | 224 | 27 | 56 | 71 | 688 | 21 | 86 | 118 | 1856 | 57 | 116 | 165 | 4672 | 37 | 146 |
| 25 | 232 | 85 | 58 | 72 | 704 | 155 | 44 | 119 | 1888 | 45 | 354 | 166 | 4736 | 71 | 444 |
| 26 | 240 | 29 | 60 | 73 | 720 | 79 | 120 | 120 | 1920 | 31 | 120 | 167 | 4800 | 71 | 120 |
| 27 | 248 | 33 | 62 | 74 | 736 | 139 | 92 | 121 | 1952 | 59 | 610 | 168 | 4864 | 37 | 152 |
| 28 | 256 | 15 | 32 | 75 | 752 | 23 | 94 | 122 | 1984 | 185 | 124 | 169 | 4928 | 39 | 462 |
| 29 | 264 | 17 | 198 | 76 | 768 | 217 | 48 | 123 | 2016 | 113 | 420 | 170 | 4992 | 127 | 234 |
| 30 | 272 | 33 | 68 | 77 | 784 | 25 | 98 | 124 | 2048 | 31 | 64 | 171 | 5056 | 39 | 158 |
| 31 | 280 | 103 | 210 | 78 | 800 | 17 | 80 | 125 | 2112 | 17 | 66 | 172 | 5120 | 39 | 80 |
| 32 | 288 | 19 | 36 | 79 | 816 | 127 | 102 | 126 | 2176 | 171 | 136 | 173 | 5184 | 31 | 96 |
| 33 | 296 | 19 | 74 | 80 | 832 | 25 | 52 | 127 | 2240 | 209 | 420 | 174 | 5248 | 113 | 902 |
| 34 | 304 | 37 | 76 | 81 | 848 | 239 | 106 | 128 | 2304 | 253 | 216 | 175 | 5312 | 41 | 166 |
| 35 | 312 | 19 | 78 | 82 | 864 | 17 | 48 | 129 | 2368 | 367 | 444 | 176 | 5376 | 251 | 336 |
| 36 | 320 | 21 | 120 | 83 | 880 | 137 | 110 | 130 | 2432 | 265 | 456 | 177 | 5440 | 43 | 170 |
| 37 | 328 | 21 | 82 | 84 | 896 | 215 | 112 | 131 | 2496 | 181 | 468 | 178 | 5504 | 21 | 86 |
| 38 | 336 | 115 | 84 | 85 | 912 | 29 | 114 | 132 | 2560 | 39 | 80 | 179 | 5568 | 43 | 174 |
| 39 | 344 | 193 | 86 | 86 | 928 | 15 | 58 | 133 | 2624 | 27 | 164 | 180 | 5632 | 45 | 176 |
| 40 | 352 | 21 | 44 | 87 | 944 | 147 | 118 | 134 | 2688 | 127 | 504 | 181 | 5696 | 45 | 178 |
| 41 | 360 | 133 | 90 | 88 | 960 | 29 | 60 | 135 | 2752 | 143 | 172 | 182 | 5760 | 161 | 120 |
| 42 | 368 | 81 | 46 | 89 | 976 | 59 | 122 | 136 | 2816 | 43 | 88 | 183 | 5824 | 89 | 182 |
| 43 | 376 | 45 | 94 | 90 | 992 | 65 | 124 | 137 | 2880 | 29 | 300 | 184 | 5888 | 323 | 184 |
| 44 | 384 | 23 | 48 | 91 | 1008 | 55 | 84 | 138 | 2944 | 45 | 92 | 185 | 5952 | 47 | 186 |
| 45 | 392 | 243 | 98 | 92 | 1024 | 31 | 64 | 139 | 3008 | 157 | 188 | 186 | 6016 | 23 | 94 |
| 46 | 400 | 151 | 40 | 93 | 1056 | 17 | 66 | 140 | 3072 | 47 | 96 | 187 | 6080 | 47 | 190 |
| 47 | 408 | 155 | 102 | 94 | 1088 | 171 | 204 | 141 | 3136 | 13 | 28 | 188 | 6144 | 263 | 480 |

FIG. 2

Communications
system 30

Wireless

Second
device 302

First device
301

FIG. 3

S401: A first device obtains a
modulation and coding scheme MCS

S402: The first device determines,
based on the obtained MCS, an
encoding code rate for sending a current
transport block

S403:
Compare a value
of a first code rate with a
value of a second code rate, to
determine whether the first code
rate is greater than or equal
to the second
code rate

Yes

No

S404: Use a maximum
encoded length of an LDPC
code as a reference length
for segmentation of the
transport block

S405: Use a product of the
first code rate and a
maximum encoded length
as a reference length for
segmentation of the current
transport block

S406: The first device determines a
quantity of code blocks into which the
transport block is to be segmented

FIG. 4

FIG. 5

FIG. 6

S701: A first
device determines, through
comparison, whether a length obtained
by encoding a transport block is greater
than or equal to a smaller
value in $N_{IR}$ and G

Yes

No

S703: The first device determines, based on a maximum code block length $K_{max}$ of an LDPC, a quantity of code blocks into which the transport block is to be segmented

S702: The first device determines, based on a length of the transport block and a minimum code rate of an LDPC, a quantity of code blocks into which the transport block is to be segmented

FIG. 7

80

801 802

Processor

Transceiver

Bus

803

Memory

Apparatus

FIG. 8

90

902                                903

Processor        User interface

Bus

901

Memory

Apparatus

FIG. 9

100

1001                            1002

Obtaining unit        First determining unit

Apparatus

FIG. 10

110

1101                            1102

Fourth determining unit        Fifth determining unit

Apparatus

FIG. 11